# EUROPEAN PATENT SPECIFICATION

(11) **EP 1 435 669 B1**
(45) Date of publication and mention of the grant of the patent: **13.05.2009**
(21) Application number: 03079144.6
(22) Date of filing: 19.12.2003
(51) Int. Cl.: H01L 51/52

(54) **Efficient electroluminescent device**
Leuchtdiode
Dispositif électroluminescent

(30) Priority: 31.12.2002 US 334324; 09.09.2003 US 658010
(43) Date of publication of application: 07.07.2004
(73) Proprietor: Eastman Kodak Company, Rochester NY 14650-2201 (US)
(72) Inventor: Brown, Christopher T., c/o Eastman Kodak Company, Rochester, New York 14650-2201 (US); Hatwar, Tukaram K., c/o Eastman Kodak Company, Rochester, New York 14650-2201 (US)
(74) Representative: Weber, Etienne Nicolas

(56) References cited:
- EP-A- 1 235 466
- EP-A1- 1 221 473
- US-A- 6 004 685
- US-A1- 2002 168 544
- XU SHAO-HONG ET.AL.: "A white organic light emitting diode with improved stability" JOURNAL OF PHYSICS D: APPLIED PHYSICS, vol. 34, 2001, pages 3083-3087, XP002434096
- C.-H. KIM, J. SHINAR: "Novel bright small molecular white OLED's" PROCEEDINGS OF SPIE, vol. 4464, February 2002 (2002-02), pages 336-343, XP002434097

## Description

### FIELD OF THE INVENTION

This invention relates to an organic light emitting diode (OLED) electroluminescent (EL) device and more particularly comprising a light-emitting layer containing at least one electroluminescent component and at least two non-electroluminescent components.

### BACKGROUND OF THE INVENTION

While organic electroluminescent (EL) devices have been known for over two decades, their performance limitations have represented a barrier to many desirable applications. In simplest form, an organic EL device is comprised of an anode for hole injection, a cathode for electron injection, and an organic medium sandwiched between these electrodes to support charge recombination that yields emission of light. These devices are also commonly referred to as organic light-emitting diodes, or OLEDs. Representative of earlier organic EL devices are Gurnee et al. U.S. Pat. No. 3,172,862, issued Mar. 9, 1965; Gurnee U.S. Pat. No. 3,173,050, issued Mar. 9, 1965; Dresner, "Double Injection Electroluminescence in Anthracene", RCA Review, Vol. 30, pp. 322-334, 1969; and Dresner U.S. Pat. No. 3,710,167, issued Jan. 9, 1973. The organic layers in these devices, usually composed of a polycyclic aromatic hydrocarbon, were very thick (much greater than 1 µm). Consequently, operating voltages were very high, often >100V.

More recent organic EL devices include an organic EL element consisting of extremely thin layers (e.g. <1.0 µm) between the anode and the cathode. Herein, the organic EL element encompasses the layers between the anode and cathode electrodes. Reducing the thickness lowered the resistance of the organic layer and has enabled devices that operate at much lower voltage. In a basic two-layer EL device structure, described first in US 4,356,429, one organic layer of the EL element adjacent to the anode is specifically chosen to transport holes, therefore, it is referred to as the hole-transporting layer, and the other organic layer is specifically chosen to transport electrons, referred to as the electron-transporting layer. The interface between the two layers provides an efficient site for the recombination of the injected hole/electron pair and the resultant electroluminescence.

There have also been proposed three-layer organic EL devices that contain an organic light-emitting layer (LEL) between the hole- transporting layer and electron-transporting layer, such as that disclosed by Tang et al [J Applied Physics, Vol. 65, Pages 3610-3616, 1989]. The light-emitting layer commonly consists of a non-electroluminescent component material doped with a guest material - electroluminescent component, which results in an efficiency improvement and allows color tuning.

Since these early inventions, further improvements in device materials have resulted in improved performance in attributes such as color, stability, luminance efficiency and manufacturability, e.g., as disclosed in US 5,061,569, US 5,409,783, US 5,554,450, US 5,593,788, US 5,683,823, US 5, 908,581, US 5,928,802, US 6,020,078, and US 6,208,077, amongst others.

Notwithstanding these developments, there are continuing needs for organic EL device components, such as electroluminescent and non-electroluminescent components, that will provide high luminance efficiencies combined with high color purity, long lifetimes and low operating voltages.

Document EP 1221473 refers to OLEDs with light emitting layers with three components, where only one of the three components is electroluminescent. The only component with a bandgap of less than 2.7 eV is the dopant DCJTB, which is electroluminescent. Specific examples show a combination of DCJTB with Alq and TBADN or ADN as non-electroluminescent materials.

A useful class of electroluminescent components is derived from the DCM class of compounds (4-dicyanomethylene-4H-pyrans) and disclosed in EP-A-1,162,674 ; US-A-2002/0,127,427 and US-A-5,908,581. A broad emission envelope and a high luminance quantum yield characterize these materials. However, the operational stability, operational drive voltage, color purity and EL efficiency of these materials in an OLED is insufficient for a broad range of OLED applications.

Another useful class of electroluminescent compounds is the periflanthene class of materials as disclosed in EP-A-1,148,109; EP-A-1,235,466; EP-A-1,182,244; US 6,004,685; Bard et al [J. Organic Chemistry, Vol. 62, Pages 530-537, 1997; J. American Chemical Society, Vol. 118, Pages 2374-2379, 1996]. These materials are characterized by a "perylene-type" emission in the red region of the visible spectrum.

However, these devices do not have good EL characteristics and typically exhibit very high drive voltage.

It is a problem to be solved to provide an OLED device having a light-emitting layer (LEL) that exhibits improved drive voltage requirement.

### SUMMARY OF THE INVENTION

The invention provides an OLED device comprising a light emitting layer containing an electroluminescent component having a first bandgap and at least two non-electroluminescent components having second and further bandgaps, respectively, wherein:
i) the second bandgap is equal to or greater than the first bandgap but is not more than 2.7 eV;
ii) the further bandgaps are greater than the first and second bandgaps;
iii) the non-electroluminescent component with the second bandgap is present in an amount of at least 34 weight percent of the total components in the light emitting layer;
iv) the non-electroluminescent components with further bandgaps are present in a combined amount of 0.1 to 65.9 weight percent of the total components in the light emitting layer; and
v) the electroluminescent component is present in amount of 0.1 to 5 weight percent of the total components in the light emitting layer.

The invention also includes a process for making the device and such an OLED device wherein:
i) the second bandgap is equal to or greater than the first bandgap but is not more than 2.7 eV;
ii) the further bandgaps are greater than the first and second bandgaps;
iii) the non-electroluminescent component with the second bandgap is present in an amount of at least 10 weight percent of the total components in the light emitting layer;
iv) the non-electroluminescent components with further bandgaps are present in a combined amount of 0.1 to 89.9 weight percent of the total components in the light emitting layer; and
v) the electroluminescent component is a periflanthene compound and is present in amount of 0.1 to 5 weight percent of the total components in the light emitting layer;
and a device wherein:
i) the second bandgap is equal to or greater than the first bandgap but is not more than 2.7 eV;
ii) the further bandgaps are greater than the first and second bandgaps;
iii) the non-electroluminescent component with the second bandgap is present in an amount of 10 to 89.9 weight percent of the total components in the light emitting layer;
iv) the non-electroluminescent components with further bandgaps are present in a combined amount of 0.1 to 89.9 weight percent of the total components in the light emitting layer and is selected from2,2',2"-(1,3,5-benzenetriyl)tris[1-phenyl-1 H-benzimidazole] and 2-*tert-*butyl-9,10-di-(2-naphthyl)anthracene (TBADN); 5,6,11,12-tetraphenylnaphthacene (rubrene); *N*,*N*'-di-1-naphthalenyl-*N*,*N*'-diphenyl-4, 4'-diaminobiphenyl (NPB); 5,12-bis[2-(5-methylbenzothiazolyl)phenyl]-6,11-diphenylnaphthacene (DBZR); 5,12-bis[4-*tert*-butylphenyl]naphthacene (tBDPN); and 5,6,11,12-tetra-2-naphthalenylnaphthacene; and
v) the electroluminescent component is present in amount of 0.1 to 5 weight percent of the total components in the light emitting layer;
and a further device wherein:
i) the second bandgap is equal to or greater than the first bandgap but is not more than 2.7 eV;
ii) each of the further bandgaps are greater than the first and second bandgaps;
iii) the non-electroluminescent component with the second bandgap is present in an amount of 10 to 89.9 weight percent of the total components in the light emitting layer;
iv) the at least two non-electroluminescent components having further bandgaps are present in a combined amount of 0.1 to 89.9 weight percent of the total components in the light emitting layer and at least one is selected from tris(8-quinolinolato)aluminum (III) (Alq₃); 2,2',2"-(1,3,5-benzenetriyl)tris[1-phenyl-1H-benzimidazole] and 2-*tert*-butyl-9,10-di-(2-naphthyl)anthracene (TBADN); 5,6,11,12-tetraphenylnaphthacene (rubrene); *N,N'*-di-1-naphthalenyl-*N*,*N*'-diphenyl-4, 4'-diaminobiphenyl (NPB); 5,12-bis[2-(5-methylbenzothiazolyl)phenyl]-6, 11-diphenylnaphthacene (DBZR); 5,12-bis[4-*tert*-butylphenyl]naphthacene (tBDPN); and 5,6,11,12-tetra-2-naphthalenylnaphthacene.; and
v) the electroluminescent component is present in amount of 0. 1 to 5 weight percent of the total components in the light emitting layer.

It is a problem to be solved to provide an OLED device having a light-emitting layer that exhibits improved drive voltage.

### BRIEF DESCRIPTION OF THE DRAWINGS

The figure shows a cross-section of a typical OLED device wherein the light-emitting layer useful in the present invention is employed.

### DETAILED DESCRIPTION OF THE INVENTION

The invention is generally as described above.

An OLED device of the invention is a multilayer electroluminescent device comprising a cathode, an anode, and a light-emitting layer (LEL) comprising at least two non-electroluminescent components and at least one electroluminescent component, such as a periflanthene or a pyran and may include other layers such as charge-injecting layers, charge-transporting layers, and blocking layers.

The term electroluminescent component means a component which, in the combination, electroluminesces in the range of 400-700 nm.

The term non-electroluminescent component means a component for which, in the combination, does not significantly electroluminesce in the range of 400-700 nm.

The term periflanthene is a trivial name describing the central diindenoperylene structure of dibenzo{[f,f]-4,4',7,7'-tetraphenyl}-diindeno[1,2,3-*cd*:1',2',3'-*lm*]perylene. The diindenoperylene core is composed of two indene fusions with the 1,2,3 positions of an indene and the *cd* and *lm* faces of a perylene. [*The Naming and Indexing of Chemical Substances for Chemical Abstracts-A Reprint of Index IV (Chemical Substance Index Names) from the Chemical Abstracts - 1992 Index Guide;* American Chemical Society: Columbus, OH, 1992; paragraph 135,148 and 150. The first description of a periflanthene was in 1937 (Braun, J.; Manz, G., Ber. 1937, 70, 1603). In this case indene can also include analogous materials wherein the benzo-group of indene can be a ring of 5, 6, or 7 atoms comprising carbon or heteroatoms such as nitrogen, sulfur or oxygen.

The compound designated as Invention 1 and related Inventions 2-8 "diindenoperylene" compounds can be prepared *via* standard accepted protocols involving aluminum/chloride (Braun, J.; Manz, G., Ber. 1937, 70, 1603), cobalt(III)fluoride (Debad, J. D.; Morris, J. C.; Lynch, V.; Magnus, P.; Bard, A. J. Am. Chem. Soc. 1996, 118, 2374-2379) and thallium trifluoracetate (Feiler, L.; Langhals, H.; Polborn, K. Liebigs Ann. 1995, 1229-1244).

Suitably, the light-emitting layer of the device comprises at least two non-electroluminescent components and at least one electroluminescent component where the electroluminescent component is present in an amount of 0.1 to 5 wt% of the total components in the light emitting layer, more typically from 0.1-2.0 wt % of the total components in the light emitting layer. This electroluminescent component has a first bandgap. The non-electroluminescent components function as an initial "energy capture agent" that transfers that energy to the electroluminescent component or guest material as the primary light emitter. The non-electroluminescent component is comprised of at least two non-electroluminescent compounds with second and further bandgaps. The non-electroluminescent component with a second bandgap is present in the light emitting layer in an amount of at least 34 wt% and not greater than 99.8 wt %. Typically, the content is at least 40 wt% with a range of 40-75 wt% being desirably employed.

The benefit imparted by the electroluminescent component does not appear to be non-electroluminescent component specific. Desirable non-electroluminescent components include those based on a chelated oxinoid compound, a benzazole, a anthracene, tetracene or an tetrarylbenzidine compound although they are not limited to these three classes of non-electroluminescent component. Particular examples of non-electroluminescent components are tris(8-quinolinolato)aluminum (III); 2,2',2"-(1,3,5-benzenetriyl)tris[1-phenyl-1H-benzimidazole] and 2-*tert*-butyl-9,10-di-(2-naphthyl)anthracene; 5,6,11,12-tetraphenylnaphthacene (Rubrene, Inv-16); *N,N'*-di-1-naphthalenyl-*N,N'-*diphenyl-4, 4'-diaminobiphenyl (NPB, Inv-21); 5,12-bis[2-(5-methylbenzothiazolyl)phenyl]-6,11-diphenylnaphthacene (DBZR, Inv-18); 5,12-bis[4-*tert*-butylphenyl]naphthacene (tBDPN, Inv-20), 5,6,11,12-tetra-2-naphthalenylnaphthacene (NR, Inv-17).

Embodiments of the electroluminescent components useful in the invention provide an emitted light having a red hue. Substituents are selected to provide embodiments that exhibit a reduced loss of initial luminance compared to the device containing no diindenoperylene of claim 1.

Electroluminescent components useful in the invention are suitably represented by Formula **(1)**: 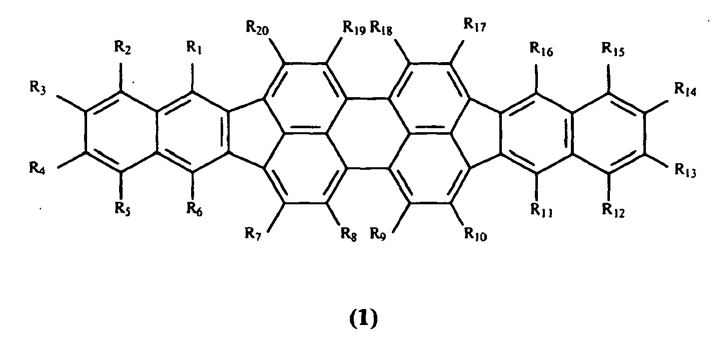 wherein:
R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀ are independently selected as hydrogen or substituents;
provided that any of the indicated substituents may join to form further fused rings.

A useful and convenient embodiment is where R₁, R₆, R₁₁, R₁₆ are all phenyl and R₂, R₃, R₄, R₅, R₇, R₈, R₉, R₁₀, R₁₂, R₁₃, R₁₄, R₁₅, R₁₇, R₁₈, R₁₉, and R₂₀ are all hydrogen. A related embodiment is when there are no phenyl groups. Another desirable embodiment is where R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, and R₂₀ are selected independently from the group consisting of hydrogen, alkyl and aryl.

The emission wavelength of these compounds may be adjusted to some extent by appropriate substitution around the central perylene core.

| Compound | Emission Color | Structure |
|---|---|---|
| Comparative | Green | 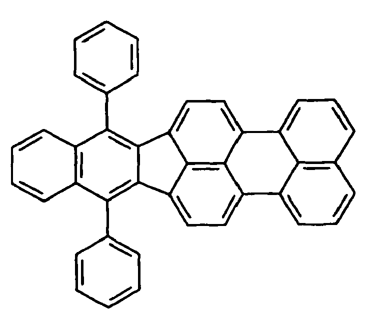 |
| Inventive | Red | 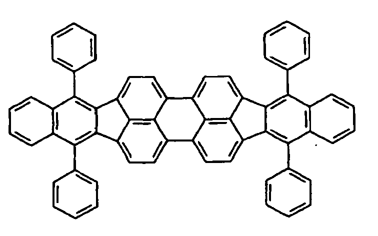 |
| Comparative | Blue | 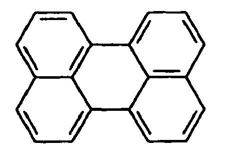 |

Further electroluminescent compounds useful in the invention are pyran derivatives suitably represented by Formula **(2)**: 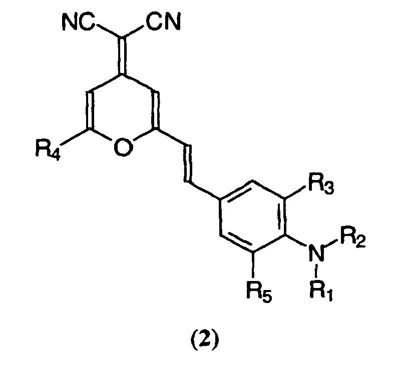 wherein:
R₁, R₂, R₃, R₄, R₅ are independently selected as hydrogen or substituents;
provided that any of the indicated substituents may join to form further fused rings.

A useful and convenient embodiment is where R₁, R₂, R₃, R₄, R₅ are selected independently from the group consisting of hydrogen, alkyl and aryl.

The electroluminescent component is usually doped into a non-electroluminescent component, which represents the light-emitting layer between the hole-transporting and electron-transporting layers. The non-electroluminescent component is chosen such that there is efficient formation of an excited state on the electroluminescent component thereby affording a bright, highly-efficient, stable EL device.

Non-electroluminescent components useful in the invention are any of those known in the art that meet the band gap requirements of the invention and are suitably represented by Formula **(3)**: 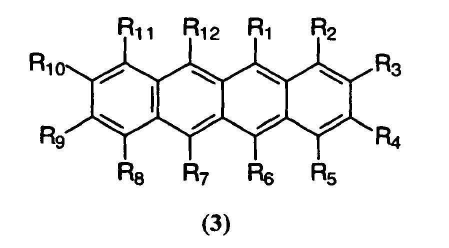 wherein:
R₁, R₂, R₃, R₄, R₅, R₆, R₇, R₈, R₉, R₁₀, R₁₁, and R₁₂ are independently selected as hydrogen or substituents;
provided that any of the indicated substituents may join to form further fused rings.

A useful and convenient embodiment is where at least one of R₁, R₂, R₃, R₄, R₅, R₆, R₇, R₈, R₉, R₁₀, R₁₁, and R₁₂ are independently selected from the group consisting of halide, alkyl, aryl, alkoxy and aryloxy groups.

The EL device of the invention is useful in any device where stable light emission is desired such as a lamp or a component in a static or motion imaging device, such as a television, cell phone, DVD player, or computer monitor.

Illustrative examples of diindeno[1,2,3-*cd*]perylene, pyran, naphthacene, indeno[1,2,3-*cd*]perylene, chelated oxinoid, anthracenyl and *N*,*N*',*N*,*N*'-tetraarylbenzidine compounds useful in the present invention are the following:

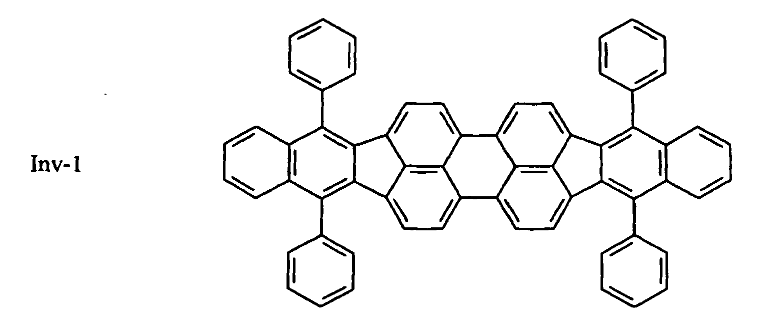

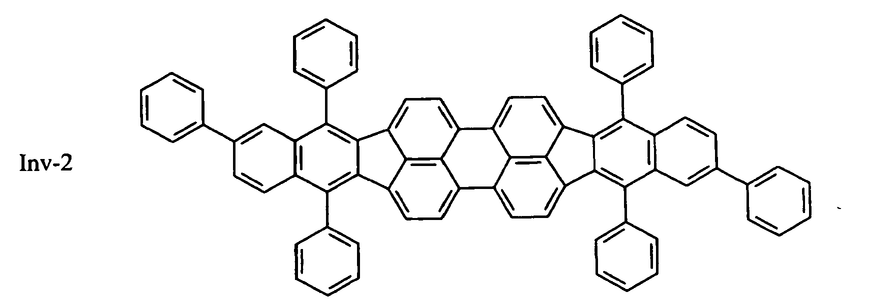

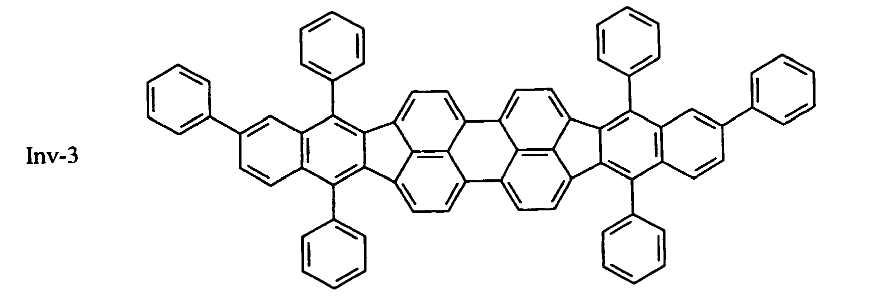

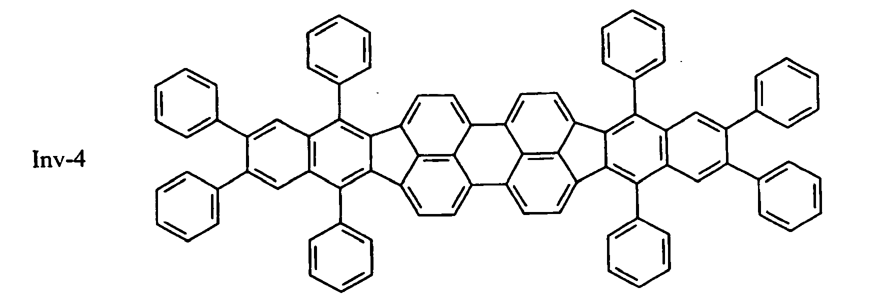

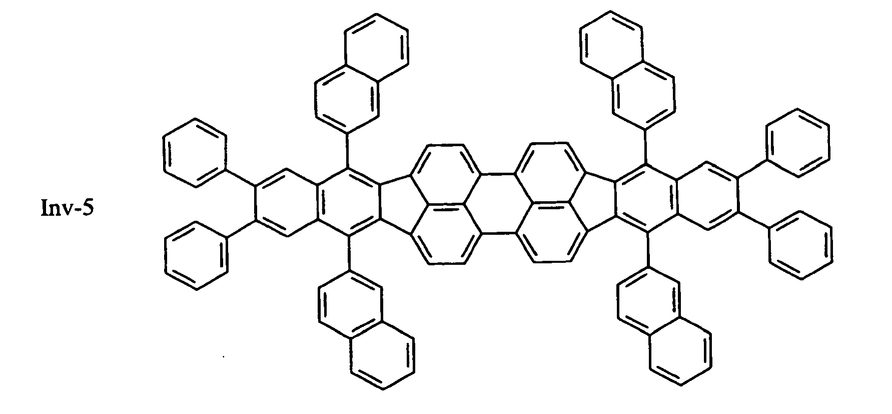

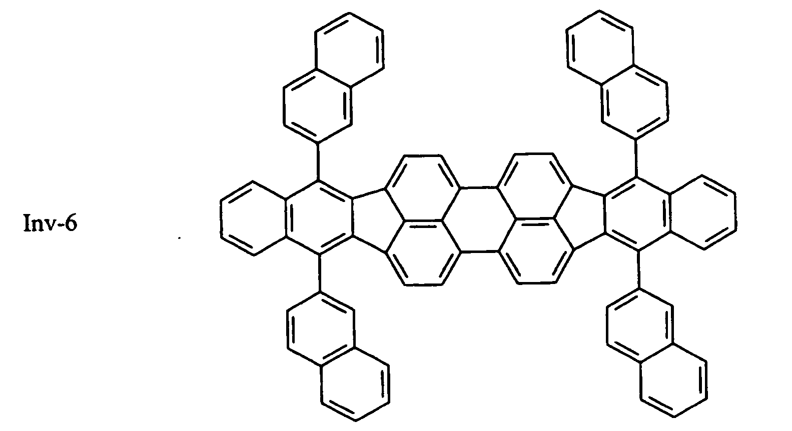

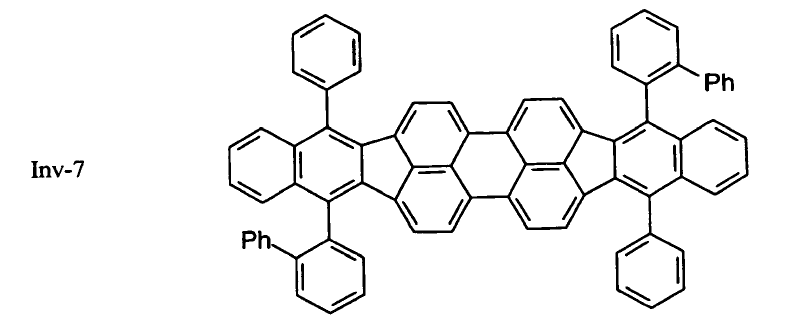

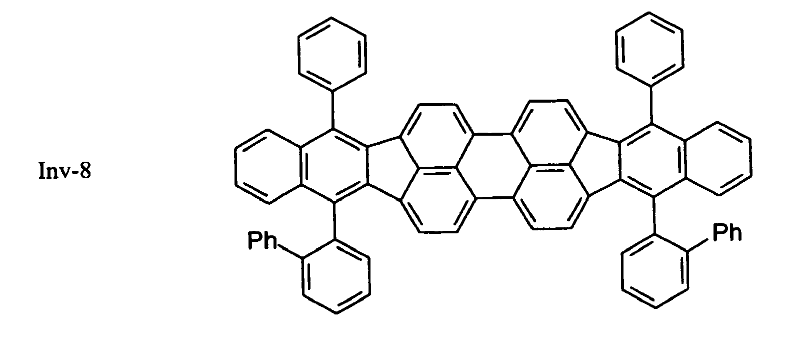

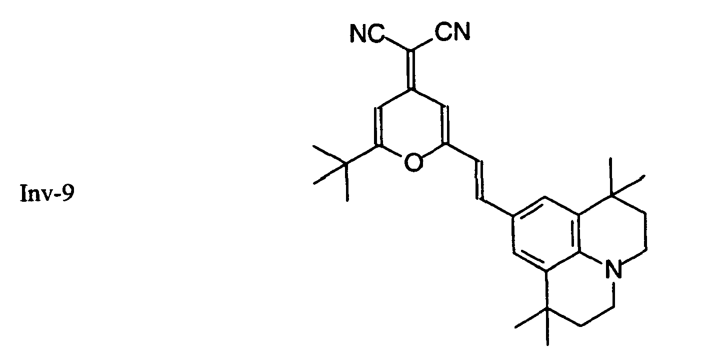

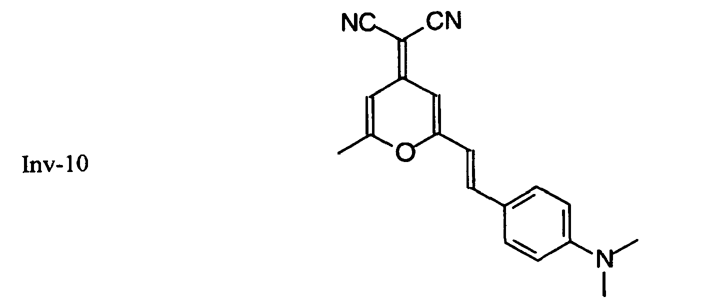

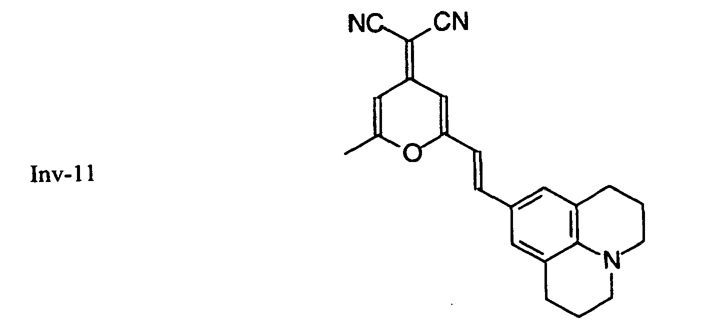

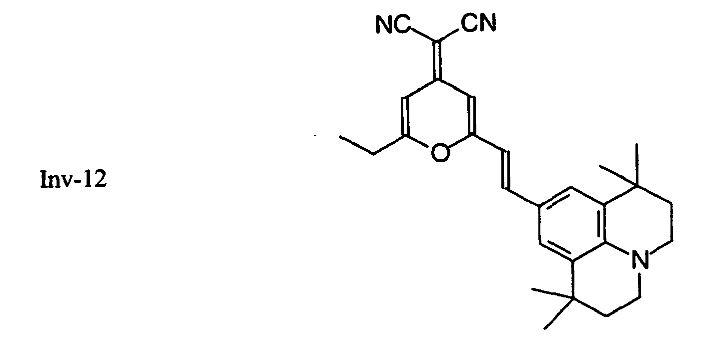

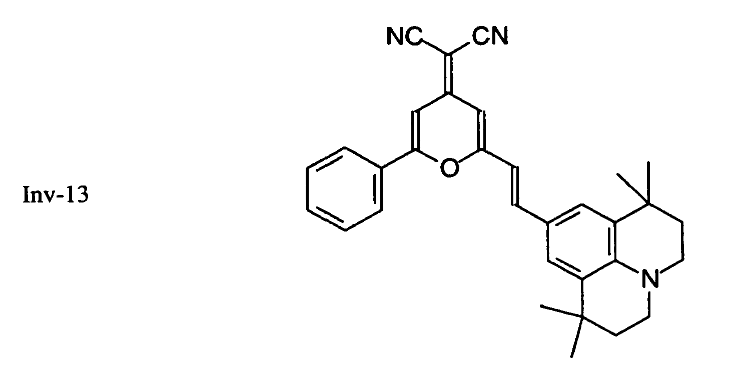

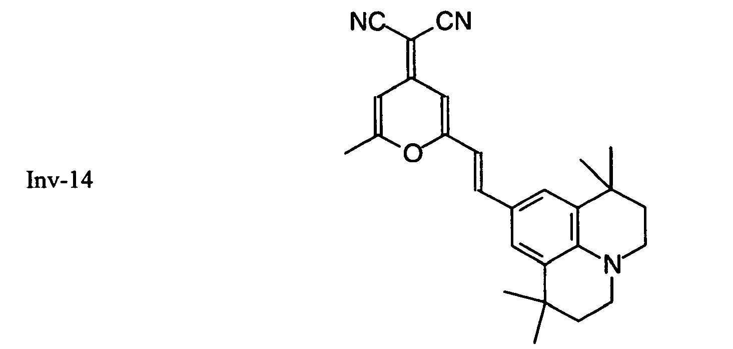

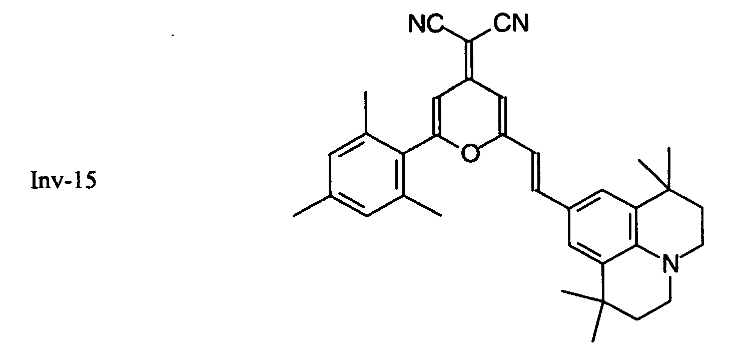

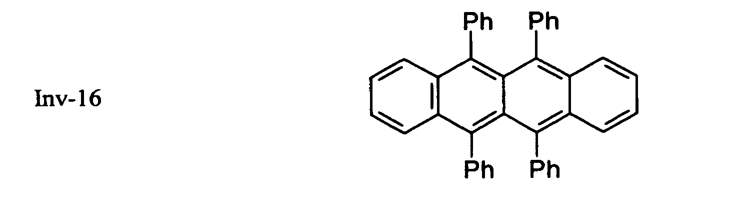

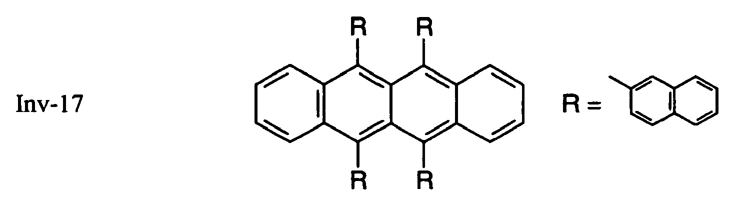

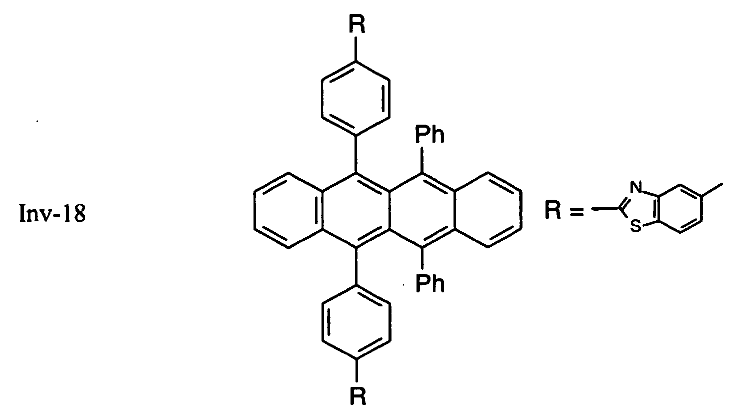

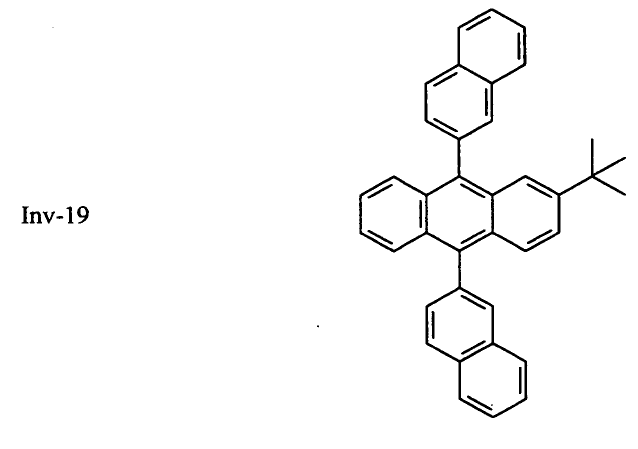

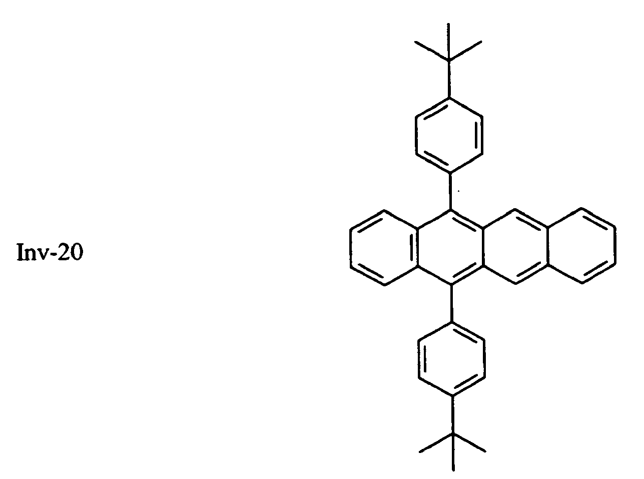

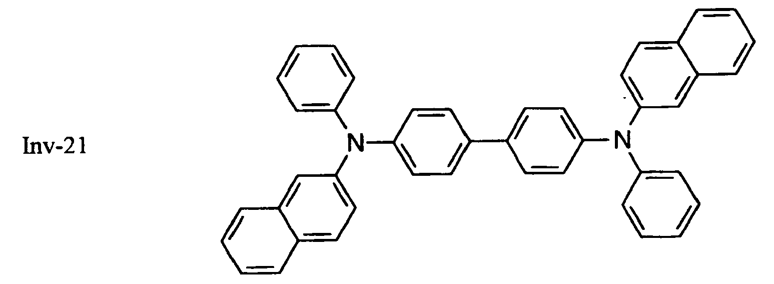

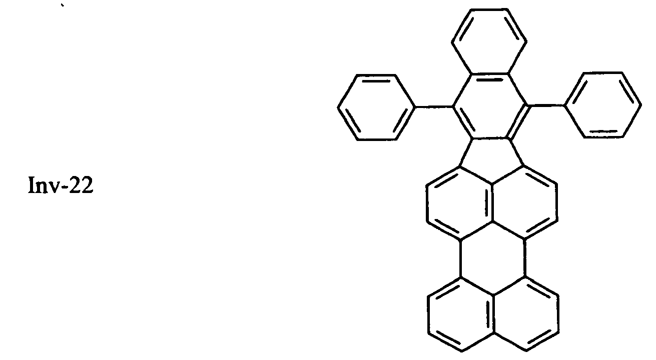

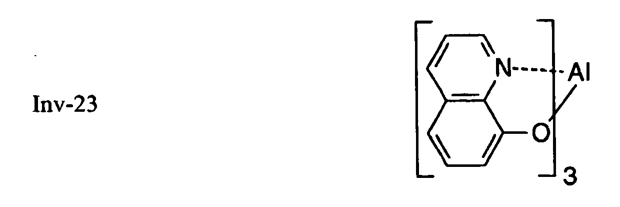

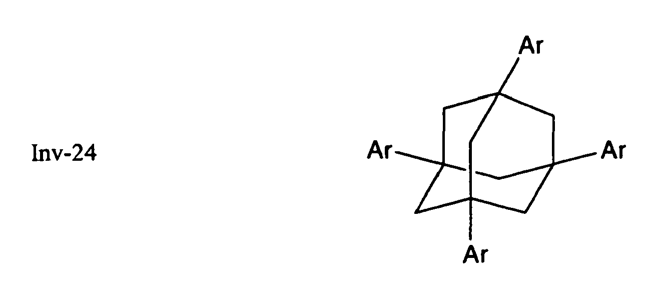

In one embodiment of the invention, the component with the second bandgap comprises at least 10 wt% of the layer and the electroluminescent component is a periflanthene. In another embodiment, the component with the second bandgap comprises 10-89.9 wt% of the layer and the components with the further bandgaps are selected from a specified listing of 2,2',2"-(1,3,5-benzenetriyl)tris[1-phenyl-1H-benzimidazole] and 2-*tert*-butyl-9,10-di-(2-naphthyl)anthracene (TBADN); 5,6,11,12-tetraphenylnaphthacene (rubrene); *N*,*N*'-di-1-naphthalenyl-*N*,*N*'-diphenyl-4, 4'-diaminobiphenyl (NPB); 5,12-bis[2-(5-methylbenzothiazolyl)phenyl]-6, 11-diphenylnaphthacene (DBZR); 5,12-bis[4-*tert*-butylphenyl]naphthacene (tBDPN); and 5,6,11,12-tetra-2-naphthalenylnaphthacene; and in a still further embodiment there are present at least two components with a further bandgap comprising at least one selected from tris(8-quinolinolato)aluminum (III) (Alq₃); 2,2',2"-(1,3,5-benzenetriyl)tris[1-phenyl-1H-benzimidazole] and 2-*tert*-butyl-9,10-di-(2-naphthyl)anthracene (TBADN); 5,6,11,12-tetraphenylnaphthacene (rubrene); *N*,*N*'-di-1-naphthalenyl-*N*,*N*'-diphenyl-4, 4'-diaminobiphenyl (NPB); 5,12-bis[2-(5-methylbenzothiazolyl)phenyt]-6,11-diphenylnaphthacene (DBZR); 5,12-bis[4-*tert*-butylphenyl]naphthacene (tBDPN); and 5,6,11,12-tetra-2-naphthalenylnaphthacene.

Typical embodiments of the invention provide not only improved drive voltage but can also provide improved luminance efficiency, operational stability and color purity (chromaticity).

Unless otherwise specifically stated, use of the term "substituted" or "substituent" means any group or atom other than hydrogen (what about deuterium). Additionally, when the term "group" is used, it means that when a substituent group contains a substitutable hydrogen, it is also intended to encompass not only the substituent's unsubstituted form, but also its form further substituted with any substituent group or groups as herein mentioned, so long as the substituent does not destroy properties necessary for device utility. Suitably, a substituent group may be halogen or may be bonded to the remainder of the molecule by an atom of carbon, silicon, oxygen, nitrogen, phosphorous, sulfur, selenium, or boron. The substituent may be, for example, halogen, such as chloro, bromo or fluoro; nitro; hydroxyl; cyano; carboxyl; or groups which may be further substituted, such as alkyl, including straight or branched chain or cyclic alkyl, such as methyl, trifluoromethyl, ethyl, *t*-butyl, 3-(2,4-di-*t*-pentylphenoxy) propyl, and tetradecyl; alkenyl, such as ethylene, 2-butene; alkoxy, such as methoxy, ethoxy, propoxy, butoxy, 2-methoxyethoxy, *sec*-butoxy, hexyloxy, 2-ethylhexyloxy, tetradecyloxy, 2-(2,4-di-*t*-pentylphenoxy)ethoxy, and 2-dodecyloxyethoxy; aryl such as phenyl, 4-*t*-butylphenyl, 2,4,6-trimethylphenyl, naphthyl; aryloxy, such as phenoxy, 2-methylphenoxy, alpha- or beta-naphthyloxy, and 4-tolyloxy; carbonamido, such as acetamido, benzamido, butyramido, tetradecanamido, alpha-(2,4-di-*t*-pentyl-phenoxy)acetamido, alpha-(2,4-di-*t*-pentylphenoxy)butyramido, alpha-(3-pentadecylphenoxy)-hexanamido, alpha-(4-hydroxy-3-*t*-butylphenoxy)-tetradecanamido, 2-oxo-pyrrolidin-1-yl, 2-oxo-5-tetradecylpyrrolin-1-yl, *N*-methyltetradecanamido, *N*-succinimido, *N-*phthalimido, 2,5-dioxo-1-oxazolidinyl, 3-dodecyl-2,5-dioxo-1-imidazolyl, and *N-*acetyl-*N*-dodecylamino, ethoxycarbonylamino, phenoxycarbonylamino, benzyloxycarbonylamino, hexadecyloxycarbonylamino, 2,4-di-*t-*butylphenoxycarbonylamino, phenylcarbonylamino, 2,5-(di-*t-*pentylphenyl)carbonylamino, *p*-dodecyl-phenylcarbonylamino, *p-*tolylcarbonylamino, *N*-methylureido, *N,N*-dimethylureido, *N*-methyl-*N-*dodecylureido, *N*-hexadecylureido, *N,N*-dioctadecylureido, *N,N-*dioctyl-*N'-*ethylureido, *N-*phenylureido, *N,N*-diphenylureido, *N*-phenyl-*N*-*p*-tolylureido, *N-*(*m*-hexadecylphenyl)ureido, *N,N*-(2,5-di-*t*-pentylphenyl)-*N'*-ethylureido, and *t-*butylcarbonamido; sulfonamido, such as methylsulfonamido, benzenesulfonamido, *p*-tolylsulfonamido, *p*-dodecylbenzenesulfonamido, *N*-methyltetradecylsulfonamido, *N,N*-dipropyl-sulfamoylamino, and hexadecylsulfonamido; sulfamoyl, such as *N*-methylsulfamoyl, N-ethylsulfamoyl, *N,N-*dipropylsulfamoyl, *N*-hexadecylsulfamoyl, *N,N*-dimethylsulfamoyl, *N-*[3-(dodecyloxy)propyl]sulfamoyl, *N-*[4-(2,4-di-*t*-pentylphenoxy)butyl]sulfamoyl, *N-*methyl-*N*-tetradecylsulfamoyl, and *N*-dodecylsulfamoyl; carbamoyl, such as *N-*methylcarbamoyl, *N,N-*dibutylcarbamoyl, *N*-octadecylcarbamoyl, *N*-[4-(2,4-di-*t-*pentylphenoxy)butyl]carbamoyl, *N*-methyl-*N*-tetradecylcarbamoyl, and *N,N-*dioctylcarbamoyl; acyl, such as acetyl, (2,4-di-*t*-amylphenoxy)acetyl, phenoxycarbonyl, *p*-dodecyloxyphenoxycarbonyl methoxycarbonyl, butoxycarbonyl, tetradecyloxycarbonyl, ethoxycarbonyl, benzyloxycarbonyl, 3-pentadecyloxycarbonyl, and dodecyloxycarbonyl; sulfonyl, such as methoxysulfonyl, octyloxysulfonyl, tetradecyloxysulfonyl, 2-ethylhexyloxysulfonyl, phenoxysulfonyl, 2,4-di-*t*-pentylphenoxysulfonyl, methylsulfonyl, octylsulfonyl, 2-ethylhexylsulfonyl, dodecylsulfonyl, hexadecylsulfonyl, phenylsulfonyl, 4-nonylphenylsulfonyl, and *p*-tolylsulfonyl; sulfonyloxy, such as dodecylsulfonyloxy, and hexadecylsulfonyloxy; sulfinyl, such as methylsulfinyl, octylsulfinyl, 2-ethylhexylsulfinyl, dodecylsulfinyl, hexadecylsulfinyl, phenylsulfinyl, 4-nonylphenylsulfinyl, and *p*-tolylsulfinyl; thio, such as ethylthio, octylthio, benzylthio, tetradecylthio, 2-(2,4-di-*t-*pentylphenoxy)ethylthio, phenylthio, 2-butoxy-5-t-octylphenylthio, and *p-*tolylthio; acyloxy, such as acetyloxy, benzoyloxy, octadecanoyloxy, *p-*dodecylamidobenzoyloxy, *N*-phenylcarbamoyloxy, *N*-ethylcarbamoyloxy, and cyclohexylcarbonyloxy; amine, such as phenylanilino, 2-chloroanilino, diethylamine, dodecylamine; imino, such as 1 (*N*-phenylimido)ethyl, *N-*succinimido or 3-benzylhydantoinyl; phosphate, such as dimethylphosphate and ethylbutylphosphate; phosphite, such as diethyl and dihexylphosphite; a heterocyclic group, a heterocyclic oxy group or a heterocyclic thio group, each of which may be substituted and which contain a 3 to 7 membered heterocyclic ring composed of carbon atoms and at least one hetero atom selected from the group consisting of oxygen, nitrogen, sulfur, phosphorous, or boron. Such as 2-furyl, 2-thienyl, 2-benzimidazolyloxy or 2-benzothiazolyl; quaternary ammonium, such as triethylammonium; quaternary phosphonium, such as triphenylphosphonium; and silyloxy, such as trimethylsilyloxy.

If desired, the substituents may themselves be further substituted one or more times with the described substituent groups. The particular substituents used may be selected by those skilled in the art to attain desirable properties for a specific application and can include, for example, electron-withdrawing groups, electron-donating groups, and steric groups. When a molecule may have two or more substituents, the substituents may be joined together to form a ring such as a fused ring unless otherwise provided. Generally, the above groups and substituents thereof may include those having up to 48 carbon atoms, typically 1 to 36 carbon atoms and usually less than 24 carbon atoms, but greater numbers are possible depending on the particular substituents selected.

### General device architecture

The present invention can be employed in most OLED device configurations. These include very simple structures comprising a single anode and cathode to more complex devices, such as passive matrix displays comprised of orthogonal arrays of anodes and cathodes to form pixels, and active-matrix displays where each pixel is controlled independently, for example, with a thin film transistor (TFT).

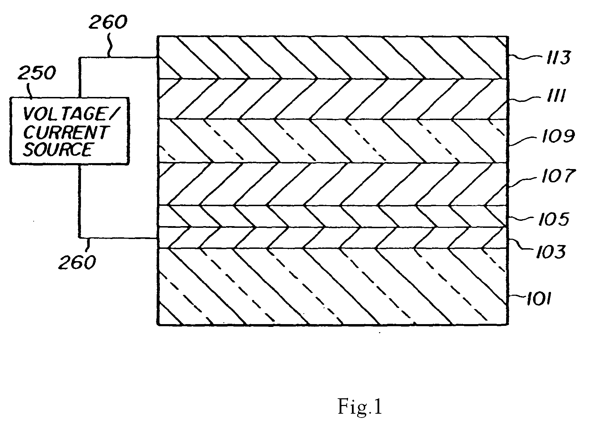

There are numerous configurations of the organic layers wherein the present invention can be successfully practiced. Essential requirements are a cathode, an anode, an HTL and an LEL. A more typical structure is shown in Figure 1 and contains a substrate **101**, an anode **103**, an optional hole-injecting layer **105**, a hole-transporting layer **107**, a light-emitting layer **109**, an electron-transporting layer **111**, and a cathode **113**. These layers are described in detail below. Note that the substrate may alternatively be located adjacent to the cathode, or the substrate may actually constitute the anode or cathode. Also, the total combined thickness of the organic layers is preferably less than 500 nm.

The anode and cathode of the OLED are connected to a voltage/current source **250** through electrical conductors **260**. The OLED is operated by applying a potential between the anode and cathode such that the anode is at a more positive potential than the cathode. Holes are injected into the organic EL element from the anode. Enhanced device stability can sometimes be achieved when the OLED is operated in an AC mode where, for some time period in cycle, the potential bias is reversed and no current flows. An example of an AC driven OLED is described in US 5,552, 678.

### Substrate

The substrate **101** can either be light transmissive or opaque, depending on the intended direction of light emission. The light transmissive property is desirable for viewing the EL emission through the substrate. Transparent glass or organic material are commonly employed in such cases. For applications where the EL emission is viewed through the top electrode, the transmissive characteristic of the bottom support is immaterial, and therefore can be light transmissive, light absorbing or light reflective. Substrates for use in this case include, but are not limited to, glass, plastic, semiconductor materials, ceramics, and circuit board materials. Of course it is necessary to provide in these device configurations a light-transparent top electrode.

### Anode

The conductive anode layer **103** is commonly formed over the substrate and, when EL emission is viewed through the anode, should be transparent or substantially transparent to the emission of interest. Common transparent anode materials used in this invention are indium-tin oxide (ITO) and tin oxide, but other metal oxides can work including, but not limited to, aluminum- or indium-doped zinc oxide (IZO), magnesium-indium oxide, and nickel-tungsten oxide. In addition to these oxides, metal nitrides, such as gallium nitride, and metal selenides, such as zinc selenide, and metal sulfides, such as zinc sulfide, can be used in layer **103**. For applications where EL emission is viewed through the top electrode, the transmissive characteristics of layer **103** are immaterial and any conductive material can be used, transparent, opaque or reflective. Example conductors for this application include, but are not limited to, gold, iridium, molybdenum, palladium, and platinum. Typical anode materials, transmissive or otherwise, have a work function of 4.1 eV or greater. Desired anode materials are commonly deposited by any suitable means such as evaporation, sputtering, chemical vapor deposition, or electrochemical means. Anodes can be patterned using well-known photolithographic processes.

### Hole-Injecting Layer (HIL)

While not always necessary, it is often useful that a hole-injecting layer **105** be provided between anode **103** and hole-transporting layer **107**. The hole-injecting material can serve to improve the film formation property of subsequent organic layers and to facilitate injection of holes into the hole-transporting layer. Suitable materials for use in the hole-injecting layer include, but are not limited to, porphyrinic compounds such as those described in US 4,720,432, and plasma-deposited fluorocarbon polymers such as those described in US 6,208,075. Alternative hole-injecting materials reportedly useful in organic EL devices are described in EP 0 891 121 A1 and EP 1 029 909 A1.

### Hole-Transporting Layer (HTL)

The hole-transporting layer **107** of the organic EL device contains at least one hole-transporting compound such as an aromatic tertiary amine, where the latter is understood to be a compound containing at least one trivalent nitrogen atom that is bonded only to carbon atoms, at least one of which is a member of an aromatic ring. In one form the aromatic tertiary amine can be an arylamine, such as a monoarylamine, diarylamine, triarylamine, or a polymeric arylamine group. Exemplary monomeric triarylamines are illustrated by Klupfel et al. US 3,180,730. Other suitable triarylamines substituted with one or more vinyl radicals and/or comprising at least one active hydrogen containing group are disclosed by Brantley et al US 3,567,450 and US 3,658,520.

A more preferred class of aromatic tertiary amines are those which include at least two aromatic tertiary amine moieties as described in US 4,720,432 and US 5,061,569. Such compounds include those represented by structural formula (A). 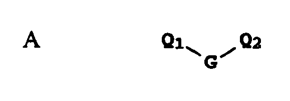 wherein Q₁ and Q₂ are independently selected aromatic tertiary amine moieties and G is a linking group such as an arylene, cycloalkylene, or alkylene group of a carbon to carbon bond. In one embodiment, at least one of Q₁ or Q₂ contains a polycyclic fused ring group, e.g., a naphthalene. When G is an aryl group, it is conveniently a phenylene, biphenylene, or naphthalene group.

A useful class of triarylamine groups satisfying structural formula (A) and containing two triarylamine groups is represented by structural formula (B): 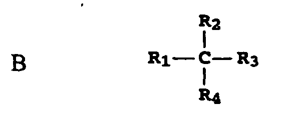 where
R₁ and R₂ each independently represents a hydrogen atom, an aryl group, or an alkyl group or R₁ and R₂ together represent the atoms completing a cycloalkyl group; and
R₃ and R₄ each independently represents an aryl group, which is in turn substituted with a diaryl substituted amino group, as indicated by structural formula (C): 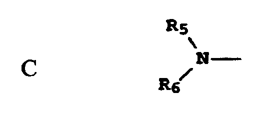 wherein R₅ and R₆ are independently selected aryl groups. In one embodiment, at least one of R₅ or R₆ contains a polycyclic fused ring group, e.g., a naphthalene.

Another class of aromatic tertiary amine groups are the tetraaryldiamines. Desirable tetraaryldiamines groups include two diarylamino groups, such as indicated by formula (C), linked through an arylene group. Useful tetraaryldiamines include those represented by formula (D). 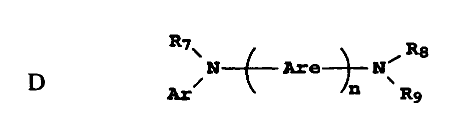 wherein
each Are is an independently selected arylene group, such as a phenylene or anthracene group,
n is an integer of from 1 to 4, and
Ar, R₇, R₈, and R₉ are independently selected aryl groups.
In a typical embodiment, at least one of Ar, R₇, R₈, and R₉ is a polycyclic fused ring group, e.g., a naphthalene

The various alkyl, alkylene, aryl, and arylene groups of the foregoing structural formulae (A), (B), (C), (D), can each in turn be substituted. Typical substituents include alkyl groups, alkoxy groups, aryl groups, aryloxy groups, and halogen such as fluoride, chloride, and bromide. The various alkyl and alkylene groups typically contain from 1 to 6 carbon atoms. The cycloalkyl moieties can contain from 3 to 10 carbon atoms, but typically contain five, six, or seven ring carbon atoms--e.g., cyclopentyl, cyclohexyl, and cycloheptyl ring structures. The aryl and arylene groups are usually phenyl and phenylene moieties.

The hole-transporting layer can be formed of a single or a mixture of aromatic tertiary amine compounds. Specifically, one may employ a triarylamine, such as a triarylamine satisfying the formula (B), in combination with a tetraaryldiamine, such as indicated by formula (D). When a triarylamine is employed in combination with a tetraaryldiamine, the latter is positioned as a layer interposed between the triarylamine and the electron injecting and transporting layer. Illustrative of useful aromatic tertiary amines are the following:
1,1-Bis(4-di-***p***-tolylaminophenyl)cyclohexane
1,1-Bis(4-di-***p***-tolylaminophenyl)-4-phenylcyclohexane
4,4'-Bis(diphenylamino)quadriphenyl
Bis(4-dimethylamino-2-methylphenyl)-phenylmethane
*N,N,N-*Tri(***p***-tolyl)amine
4-(di-***p***-tolylamino)-4'-[4(di-***p***-tolylamino)-styryl]stilbene
*N*,*N*,*N'*,*N*'-Tetra-***p***-tolyl-4-4'-diaminobiphenyl
*N,N,N;N'*-Tetraphenyl-4,4'-diaminobiphenyl
*N*,*N*,*N'*,*N'-*tetra*-*1-naphthyl-4,4'-diaminobiphenyl
*N*,*N*,*N*',*N*'-tetra-2-naphthyl-4,4'-diaminobiphenyl
*N*-Phenylcarbazole
4,4'-Bis[*N*-(1-naphthyl)-*N*-phenylamino]biphenyl
4,4'-Bis[*N*-(1-naphthyl)-*N*-(2-naphthyl)amino]biphenyl
4,4"-Bis[*N*-(1-naphthyl)-*N*-phenylamino]p-terphenyl
4,4'-Bis[*N*-(2-naphthyl)-*N*-phenylamino]biphenyl
4,4'-Bis[*N*-(3-acenaphthenyl)-*N*-phenylamino]biphenyl
1,5-Bis[*N*-(1-naphthyl)-*N*-phenylamino]naphthalene
4,4'-Bis[*N*-(9-anthryl)-*N*-phenylamino]biphenyl
4,4"-Bis[*N*-(1-anthryl)-*N*-phenylamino]-***p***-terphenyl
4,4'-Bis[*N*-(2-phenanthryl)-*N*-phenylamino]biphenyl
4,4'-Bis[*N*-(8-fluoranthenyl)-*N*-phenylamino]biphenyl
4,4'-Bis[*N*-(2-pyrenyl)-*N*-phenylamino]biphenyl
4,4'-Bis[*N*-(2-naphthacenyl)-*N*-phenylamino]biphenyl
4,4'-Bis[*N*-(2-perylenyl)-*N*-phenylamino]biphenyl
4,4'-Bis[*N*-(1-coronenyl)-N-phenylaminolbiphenyl
2,6-Bis(di-***p***-tolylamino)naphthalene
2,6-Bis[di-(1-naphthyl)amino]naphthalene
2,6-Bis[*N*-(1-naphthyl)-*N*-(2-naphthyl)amino]naphthalene
*N*,*N*,*N*',*N*'-Tetra(2-naphthyl)-4,4"-diamino-***p***-terphenyl
4,4'-Bis {*N*-phenyl-*N*-[4-(1-naphthyl)-phenyl]amino}biphenyl
4,4'-Bis[*N*-phenyl-*N*-(2-pyrenyl)amino]biphenyl
2,6-Bis[*N*,*N*-di(2-naphthyl)amine]fluorine
1,5-Bis[*N*-(1-naphthyl)-*N*-phenylamino]naphthalene

Another class of useful hole-transporting materials includes polycyclic aromatic compounds as described in EP 1 009 041. In addition, polymeric hole-transporting materials can be used such as poly(*N*-vinylcarbazole) (PVK), polythiophenes, polypyrrole, polyaniline, and copolymers such as poly(3,4-ethylenedioxythiophene) / poly(4-styrenesulfonate) also called PEDOT/PSS.

### Light-Emitting Layer (LEL)

As more fully described in US 4,769,292 and 5,935,721, the light-emitting layer (LEL) **109** of the organic EL element comprises a luminescent or fluorescent material where electroluminescence is produced as a result of electron-hole pair recombination in this region. The light-emitting layer can be comprised of a single material, but more commonly consists of a non-electroluminescent component material doped with a guest compound or compounds where light emission comes primarily from the electroluminescent component and can be of any color. The non-electroluminescent component materials in the light-emitting layer can be an electron-transporting material, as defined below, a hole-transporting material, as defined above, or another material or combination of materials that support hole-electron recombination. The electroluminescent component is usually chosen from highly fluorescent dyes, but phosphorescent compounds, e.g., transition metal complexes as described in WO 98/55561, WO 00/18851, WO 00/57676, and WO 00/70655 are also useful. Electroluminescent components are typically coated as 0.01 to 10 % by weight into the non-electroluminescent component material.

An important relationship for choosing a dye as a electroluminescent component is a comparison of the bandgap potential which is defined as the energy difference between the highest occupied molecular orbital and the lowest unoccupied molecular orbital of the molecule. For efficient energy transfer from the non-electroluminescent component to the electroluminescent component molecule, a necessary condition is that the band gap of the electroluminescent component is smaller than that of the non-electroluminescent component material.

Non-electroluminescent component and emitting molecules known to be of use include, but are not limited to, those disclosed in US 4,768,292, US 5,141,671, US 5,150,006, US 5,151,629, US 5,405,709, US 5,484,922, US 5,593,788, US 5,645,948, US 5,683,823, US 5,755,999, US 5,928,802, US 5,935,720, US 5,935,721, and US 6,020,078.

Metal complexes of 8-hydroxyquinoline and similar derivatives (Formula E) constitute one class of useful non-electroluminescent component compounds capable of supporting electroluminescence, and are particularly suitable for light emission of wavelengths longer than 500 nm, e.g., green, yellow, orange, and red. 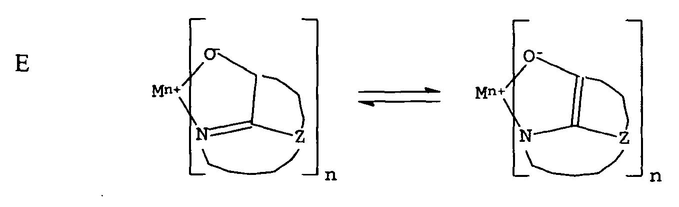 wherein
M represents a metal;
n is an integer of from 1 to 4; and
Z independently in each occurrence represents the atoms completing a nucleus having at least two fused aromatic rings.

From the foregoing it is apparent that the metal can be monovalent, divalent, trivalent, or tetravalent metal. The metal can, for example, be an alkali metal, such as lithium, sodium, or potassium; an alkaline earth metal, such as magnesium or calcium; an earth metal, such aluminum or gallium, or a transition metal such as zinc or zirconium. Generally any monovalent, divalent, trivalent, or tetravalent metal known to be a useful chelating metal can be employed.

Z completes a heterocyclic nucleus containing at least two fused aromatic rings, at least one of which is an azole or azine ring. Additional rings, including both aliphatic and aromatic rings, can be fused with the two required rings, if required. To avoid adding molecular bulk without improving on function the number of ring atoms is usually maintained at 18 or less.

Illustrative of useful chelated oxinoid compounds are the following:
CO-1: Aluminum trisoxine [alias, tris(8-quinolinolato)aluminum(III)]
CO-2: Magnesium bisoxine [alias, bis(8-quinolinolato)magnesium(II)]
CO-3: Bis[benzo{f}-8-quinolinolato]zinc (II)
CO-4: Bis(2-methyl-8-quinolinolato)aluminum(III)-µ-oxo-bis(2-methyl-8-quinolinolato) aluminum(III)
CO-5: Indium trisoxine [alias, tris(8-quinolinolato)indium]
CO-6: Aluminum tris(5-methyloxine) [alias, tris(5-methyl-8-quinolinolato) aluminum(III)]
CO-7: Lithium oxine [alias, (8-quinolinolato)lithium(I)]
CO-8: Gallium oxine [alias, tris(8-quinolinolato)gallium(III)]
CO-9: Zirconium oxine [alias, tetra(8-quinolinolato)zirconium(IV)]
CO-10: Bis(2-methyl-8-quinolinato)-4-phenylphenolatoaluminum (III)

Derivatives of 9,10-di-(2-naphthyl)anthracene (Formula F) constitute one class of useful non-electroluminescent components capable of supporting electroluminescence, and are particularly suitable for light emission of wavelengths longer than 400 nm, e.g., blue, green, yellow, orange or red.

| | |
|---|---|
| F | 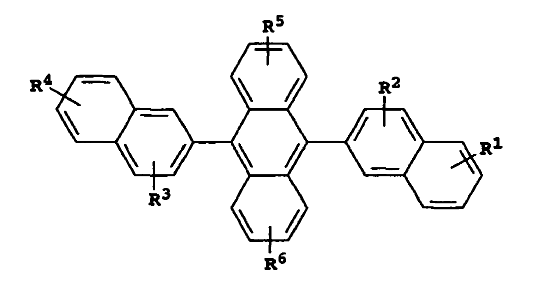 |

wherein: R¹, R², R³, R⁴, R⁵, and R⁶ represent hydrogen or one or more substituents selected from the following groups:
Group 1: hydrogen, alkyl and alkoxy groups typically having from 1 to 24 carbon atoms;
Group 2: a ring group, typically having from 6 to 20 carbon atoms;
Group 3: the atoms necessary to complete a carbocyclic fused ring group such as naphthyl, anthracenyl, pyrenyl, and perylenyl groups, typically having from 6 to 30 carbon atoms;
Group 4: the atoms necessary to complete a heterocyclic fused ring group such as furyl, thienyl, pyridyl, and quinolinyl groups, typically having from 5 to 24 carbon atoms;
Group 5: an alkoxylamino, alkylamino, and arylamino group typically having from 1 to 24 carbon atoms; and
Group 6: fluorine, chlorine, bromine and cyano radicals.

Illustrative examples include 9,10-di-(2-naphthyl)anthracene and 2-*t*-butyl-9,10-di-(2-naphthyl)anthracene. Other anthracene derivatives can be useful as a non-electroluminescent component in the LEL, including derivatives of 9,10-bis[4-(2,2-diphenylethenyl)phenyl]anthracene, and phenylanthracene derivatives as described in EP 681,019.

Benzazole derivatives (Formula G) constitute another class of useful non-electroluminescent components capable of supporting electroluminescence, and are particularly suitable for light emission of wavelengths longer than 400 nm, e.g., blue, green, yellow, orange or red. 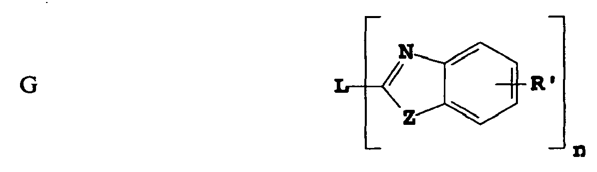 where:
n is an integer of 3 to 8;
Z is -O, -NR or -S where R is H or a substituent; and
R' represents one or more optional substituents where R and each R' are H or alkyl groups such as propyl, t-butyl, and heptyl groups typically having from 1 to 24 carbon atoms; carbocyclic or heterocyclic ring groups such as phenyl and naphthyl, furyl, thienyl, pyridyl, and quinolinyl groups and atoms necessary to complete a fused aromatic ring group typically having from 5 to 20 carbon atoms; and halo such as chloro, and fluoro;

L is a linkage unit usually comprising an alkyl or ary group which conjugately or unconjugately connects the multiple benzazoles together.

An example of a useful benzazole is 2, 2', 2"-(1,3,5-phenylene)tris[1-phenyl-1H-benzimidazole], (TPBI).

Distyrylarylene derivatives as described in US 5,121,029 are also useful non-electroluminescent component materials in the LEL.

Desirable fluorescent electroluminescent components include groups derived from fused ring, heterocyclic and other compounds such as anthracene, tetracene, xanthene, perylene, rubrene, pyran, rhodamine, quinacridone, dicyanomethylenepyran, thiopyran , polymethine, pyrilium thiapyrilium, and carbostyryl compounds. Illustrative examples of useful electroluminescent components include, but are not limited to, the following:

| | | | | | | | |
|---|---|---|---|---|---|---|---|
| 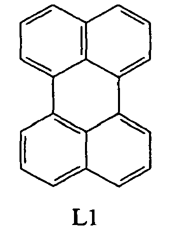 | | | | 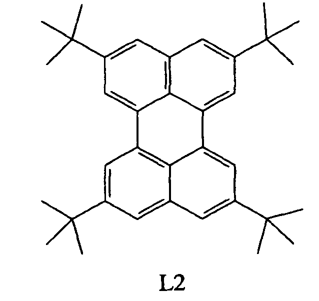 | | | |
| 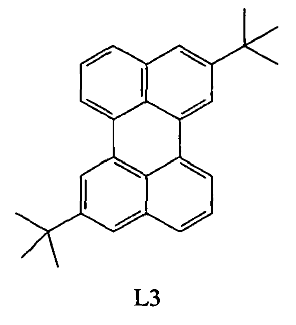 | | | | 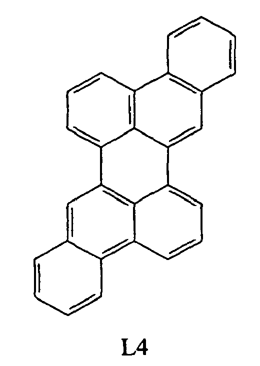 | | | |
| 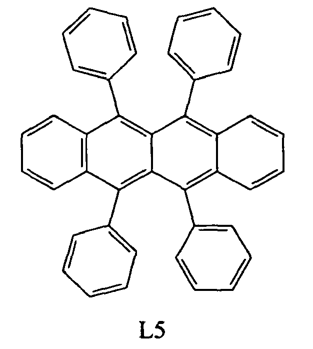 | | | | 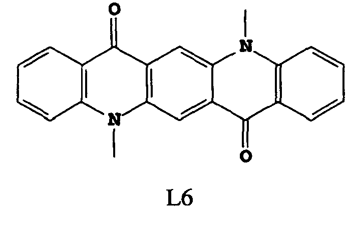 | | | |
| 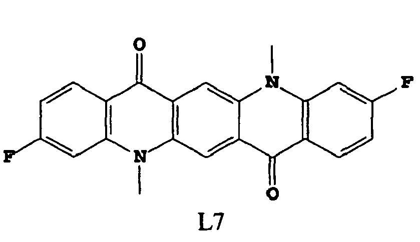 | | | | 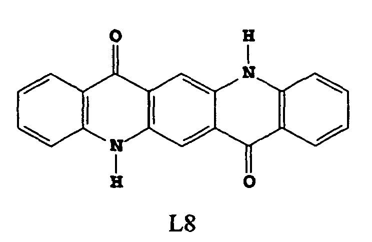 | | | |
| 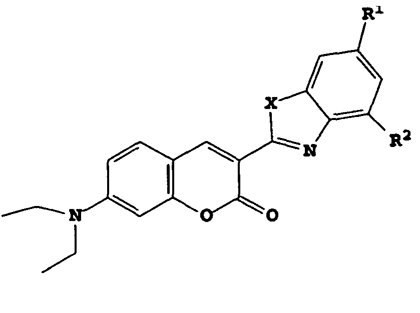 | | | | 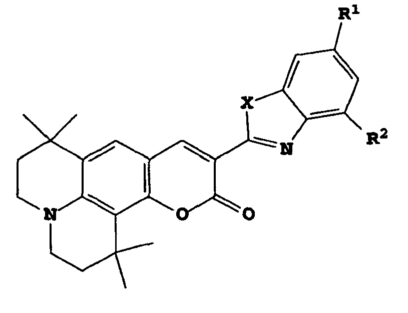 | | | |
| | **X** | **R1** | **R2** | | **X** | **R1** | **R2** |
| L9 | O | H | H | L23 | O | H | H |
| L10 | O | H | Methyl | L24 | O | H | Methyl |
| L11 | O | Methyl | H | L25 | O | Methyl | H |
| L12 | O | Methyl | Methyl | L26 | O | Methyl | Methyl |
| L13 | O | H | t-butyl | L27 | O | H | t-butyl |
| L14 | O | t-butyl | H | L28 | O | t-butyl | H |
| L15 | O | t-butyl | t-butyl | L29 | O | t-butyl | t-butyl |
| L16 | S | H | H | L30 | S | H | H |
| L17 | S | H | Methyl | L31 | S | H | Methyl |
| L18 | S | Methyl | H | L32 | S | Methyl | H |
| L19 | S | Methyl | Methyl | L33 | S | Methyl | Methyl |
| L20 | S | H | t-butyl | L34 | S | H | t-butyl |
| L21 | S | t-butyl | H | L35 | S | t-butyl | H |
| L22 | S | t-butyl | t-butyl | L36 | S | t-butyl | t-butyl |
| 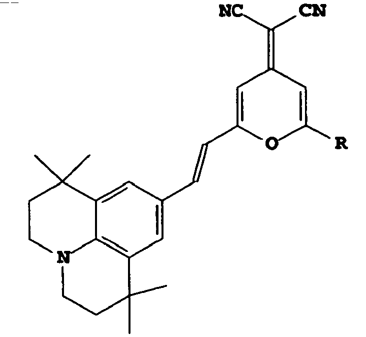 | | | | 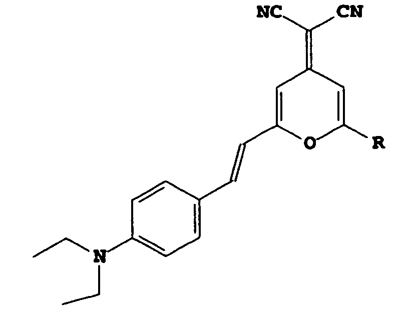 | | | |
| | **R** | | | | **R** | | |
| L37 | phenyl | | | L41 | phenyl | | |
| L38 | methyl | | | L42 | methyl | | |
| L39 | t-butyl | | | L43 | t-butyl | | |
| L40 | mesityl | | | L44 | mesityl | | |
| 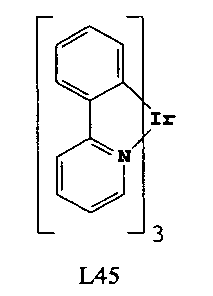 | | | | 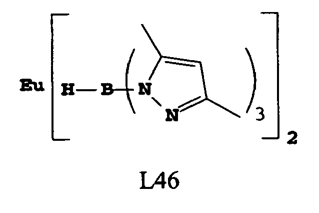 | | | |
| 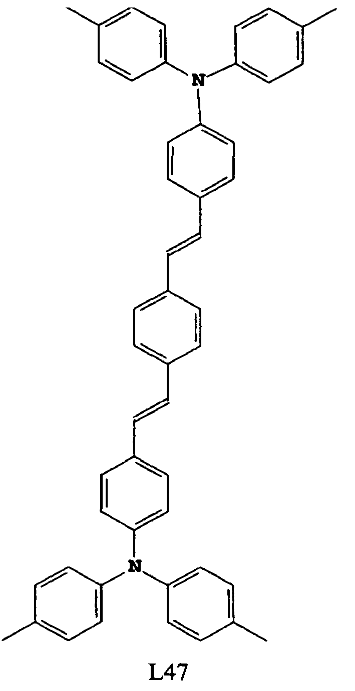 | | | | 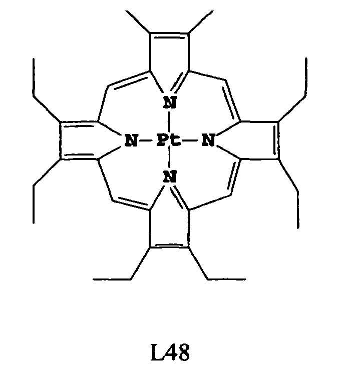 | | | |

### Electron-Transporting Layer (ETL)

Preferred thin film-forming materials for use in forming the electron-transporting layer **111** of the organic EL devices of this invention are metal chelated oxinoid compounds, including chelates of oxine itself (also commonly referred to as 8-quinolinol or 8-hydroxyquinoline). Such compounds help to inject and transport electrons and exhibit both high levels of performance and are readily fabricated in the form of thin films. Exemplary of contemplated oxinoid compounds are those satisfying structural formula (E), previously described.

Other electron-transporting materials include various butadiene derivatives as disclosed in US 4,356,429 and various heterocyclic optical brighteners as described in US 4,539,507. Benzazoles satisfying structural formula (G) are also useful electron transporting materials.

In some instances, layers **109** and **111** can optionally be collapsed into a single layer that serves the function of supporting both light emission and electron transportation.

### Cathode

When light emission is through the anode, the cathode layer **113** used in this invention can be comprised of nearly any conductive material. Desirable materials have good film-forming properties to ensure good contact with the underlying organic layer, promote electron injection at low voltage, and have good stability. Useful cathode materials often contain a low work function metal (< 4.0 eV) or metal alloy. One preferred cathode material is comprised of a Mg:Ag alloy wherein the percentage of silver is in the range of 1 to 20 %, as described in US 4,885,221. Another suitable class of cathode materials includes bilayers comprised of a thin layer of a low work function metal or metal salt capped with a thicker layer of conductive metal. One such cathode is comprised of a thin layer of LiF followed by a thicker layer of Al as described in US 5,677,572. Other useful cathode materials include, but are not limited to, those disclosed in US 5,059,861, US 5,059,862, and US 6,140,763.

When light emission is viewed through the cathode, the cathode must be transparent or nearly transparent. For such applications, metals must be thin or one must use transparent conductive oxides, or a combination of these materials. Optically transparent cathodes have been described in more detail in US 5,776,623. Cathode materials can be deposited by evaporation, sputtering, or chemical vapor deposition. When needed, patterning can be achieved through many well known methods including, but not limited to, through-mask deposition, integral shadow masking as described in US 5,276,380 and EP 0 732 868, laser ablation, and selective chemical vapor deposition.

### Deposition of organic layers

The organic materials mentioned above are suitably deposited through sublimation, but can be deposited from a solvent with an optional binder to improve film formation. If the material is a polymer, solvent deposition is usually preferred. The material to be deposited by sublimation can be vaporized from a sublimator "boat" often comprised of a tantalum material, e.g., as described in US 6,237,529, or can be first coated onto a donor sheet and then sublimed in closer proximity to the substrate. Layers with a mixture of materials can utilize separate sublimator boats or the materials can be pre-mixed and coated from a single boat or donor sheet. Patterned deposition can be achieved using shadow masks, integral shadow masks (US 5,294,870), spatially-defined thermal dye transfer from a donor sheet (US 5,851,709 and US 6,066,357) and inkjet method (US 6,066,357).

Organic materials useful in making OLEDs, for example organic hole-transporting materials, organic light-emitting materials doped with an organic electroluminescent components have relatively complex molecular structures with relatively weak molecular bonding forces, so that care must be taken to avoid decomposition of the organic material(s) during physical vapor deposition. The aforementioned organic materials are synthesized to a relatively high degree of purity, and are provided in the form of powders, flakes, or granules. Such powders or flakes have been used heretofore for placement into a physical vapor deposition source wherein heat is applied for forming a vapor by sublimation or vaporization of the organic material, the vapor condensing on a substrate to provide an organic layer thereon.

Several problems have been observed in using organic powders, flakes, or granules in physical vapor deposition: These powders, flakes, or granules are difficult to handle. These organic materials generally have a relatively low physical density and undesirably low thermal conductivity, particularly when placed in a physical vapor deposition source which is disposed in a chamber evacuated to a reduced pressure as low as 10⁻⁶ Torr. Consequently, powder particles, flakes, or granules are heated only by radiative heating from a heated source, and by conductive heating of particles or flakes directly in contact with heated surfaces of the source. Powder particles, flakes, or granules which are not in contact with heated surfaces of the source are not effectively heated by conductive heating due to a relatively low particle-to-particle contact area; This can lead to nonuniform heating of such organic materials in physical vapor deposition sources. Therefore, result in potentially nonuniform vapor-deposited organic layers formed on a substrate.

These organic powders can be consolidating into a solid pellet. These solid pellets consolidating into a solid pellet from a mixture of a sublimable organic material powder are easier to handle. Consolidation of organic powder into a solid pellet can be accomplished with relatively simple tools. A solid pellet formed from mixture comprising one or more non-luminescent organic non-electroluminescent component materials or luminescent electroluminescent component materials or mixture of non-electroluminescent component and electroluminescent component materials can be placed into a physical vapor deposition source for making organic layer. Such consolidated pellets can be used in a physical vapor deposition apparatus.

In one aspect, the present invention provides a method of making an organic layer from compacted pellets of organic materials on a substrate, which will form part of an OLED.

### Encapsulation

Most OLED devices are sensitive to moisture and/or oxygen so they are commonly sealed in an inert atmosphere such as nitrogen or argon, along with a desiccant such as alumina, bauxite, calcium sulfate, clays, silica gel, zeolites, alkaline metal oxides, alkaline earth metal oxides, sulfates, or metal halides and perchlorates. Methods for encapsulation and desiccation include, but are not limited to, those described in US 6,226,890.

### Hole Blocking Layer

Some OLED devices require a Hole-Blocking Layer to either facilitate injection of electrons into the LEL or attenuate the passage of holes into the ETL to ensure recombination in the LEL (D. F. O'brien, M. A. Baldo, M. E. Thompson, and S. R. Forrest Appl. Phys. Lett. 74, 442 (1999)). Typically this layer is thin (i.e., 10 nm) and it is located between the LEL and ETL.

### Band Gap

An important relationship exists when selecting an electroluminescent component. A comparison of the bandgap potential with respect to the bandgap(s) of the non-electroluminescent component(s) in the LEL material must be carefully considered. In order for there to be efficient energy transfer from the non-electroluminescent component to the electroluminescent component molecule, the band gap of the electroluminescent component is typically smaller than that of the non-electroluminescent component material.

The bandgaps are typically determined experimentally by UVS or XPS spectroscopic techniques to characterize the energy levels and chemical nature of the HTL, LEL and ETL layers. All bandgaps as pertaining to this application are determined by the following procedure:
1. the absorption and emission spectra for a material are measured in a nonpolar solvent such as ethylacetate or toluene at low (i.e., < 1x10⁻³ M) concentration and optical density (i.e., < 0.2) bandgaps.
2. the spectra are normalized to one via the maximum absorption and emission bands in the visible region (i.e., 350-750 nm) of the spectrum.
3. the normalized absorption and emission spectra are plotted on the same chart.
4. the wavelength between the normalized absorption and emission spectra where they cross (crossing-wavelength) is defined as E_{0,0} and this "optical" bandgap otherwise known in the art as the energy difference between the highest occupied molecular orbital (HOMO) level or the maximum level of the valence band and the lowest unoccupied molecular orbital (LUMO) level or the minimum level of the conducting band. This value is typically reported in eV and that conversion is made by dividing the "crossing-wavelength" into 1240 eV nm.

**Optical Bandgaps for Representative Materials**

| **Invention** | **Bandgap (eV)** |
|---|---|
| Inv-1 | 2.12 eV |
| Inv-9 | 2.22 eV |
| Inv-16 | 2.31 eV |
| Inv-17 | 2.27 eV |
| Inv-18 | 2.28 eV |
| Inv-19 | 3.04 eV |
| Inv-20 | 2.51 eV |
| Inv-21 | 3.15 eV |
| Inv-23 | 2.76 eV |

### EXAMPLES

The inventions and its advantages are further illustrated by the specific examples, which follow:

### TABLES IA-ID: A Mixed Non-Electroluminescent System Comprising tris-(8-quinolinato)aluminum(III), [Inv-23] and Invention 16 with Invention 1.

### Example 1- EL Device Fabrication - Inventive Examples

### Sample Preparation and Testing

EL devices satisfying the requirements of the invention as Sample 1-2 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N'*-di-1-naphthalenyl-*N,N'-*diphenyl-4, 4'-diaminobiphenyl (NPB) having a thickness of 75 nm was then evaporated from a tantalum boat.
   c) A 37.5-65.8 nm LEL comprised of tris(8-quinolinolato)aluminum (III) **(Inv-23,** 0-99.5 wt %) , 9,10,11,12-tetraphenylnaphthacene (**Inv-16**, 0-99.5 wt%) and emitter-electroluminescent component, **Inv-1**, (0.27-0.50 wt%) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table IA.

**Table IA. Evaluation Results for EL Inv-1 in Inv-23 and Inv-16**

| Sample | Inv-1 Wt%-Lum | Inv-23 Wt %-Non-Lum | Inv-16 Wt %-Non-Lum | Color ClEx,y* | Luminance Efficiency (cd/A)* | | Drive Voltage (V)* | %Efficiency Increase vs Cmp-1/avg. of Cmp-(2-4) | %Drive Voltage Decrease vs Cmp- 1 |
|---|---|---|---|---|---|---|---|---|---|
| 1 | 0.3 | 57.96 | 41.76 | 0.646,0.347 | 3.66 | | 7.0 | 193/69 | 17 |
| 2 | 0.3 | 56.96 | 42.76 | 0.647,0.347 | 3.45 | | 7.1 | 176/59 | 16 |
| Cmp-1 | 0.5 | 99.5 | 0 | 0.562,0.400 | 1.25 | | 8.4 | - | - |
| Cmp-2 | 0.5 | 0 | 99.5 | 0.627,0.359 | 2.23 | Avg. 2.17 | 5.9 | - | - |
| Cmp-3 | 0.5 | 0 | 99.5 | 0.626,0.359 | 2.18 | | 5.9 | - | - |
| Cmp-4 | 0.5 | 0 | 99.5 | 0.627,0.359 | 2.11 | | 6.0 | - | - |

| | | | | | | | | | |
|---|---|---|---|---|---|---|---|---|---|
| * Measured at 20mA/cm² constant current | | | | | | | | | |

As can be discerned from the device characteristics reported in Table IA the devices comprised of a mixture of two non-electroluminescent components are superior in efficiency and drive voltage relative to the comparative devices. The luminance efficiency of a device with a single non-electroluminescent component is relatively low, 1.25 cd/A for comparative example 1 (Cmp-1) and less than 2.23 cd/A for Cmp 2-4.

The percent improvement in operational drive voltage is significantly advantaged for devices employing the non-electroluminescent component, Inv-16. The lowest operational drive voltages are for comparative examples 2-4. However, the luminance efficiency for these devices is poor. The combination of Inv-23 and Inv-16 serves to lower the operational drive voltages by 17 and 16 percent for samples 1 and 2, respectively, versus Cmp-1 while simultaneously increasing luminance from 69-193 %.

The comparative (Cmp) examples 2-4 were averaged, 2.17, and this value was used in %efficiency calculations. Samples 1 and 2 are significantly more efficient in luminance than comparative examples 1 or 2-4. Additionally, the color of the EL from samples 1 and 2, as measured in chromaticity (CIEx,y) coordinates, is much improved (i.e., more red) compared to comparative example 1 and 2-4.

### Example 2- EL Device Fabrication - Inventive Examples

### Sample Preparation and Testing

EL devices satisfying the requirements of the invention as Sample 4 and as Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N*,*N*'-di-1-naphthalenyl-*N*,*N*'-diphenyl-4, 4'-diaminobiphenyl (NPB) having a thickness of 75 nm was then evaporated from a tantalum boat.
   c) A 37.5-67.2 nm LEL comprised of tris(8-quinolinolato)aluminum (III) **(Inv-23**, 0-99.5 wt%) , 9,10,11,12-tetraphenylnaphthacene **(Inv-16,** 0-99.5 wt%) and emitter-electroluminescent component, **Inv-1,** (0.30-0.50 wt%) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table IB.

**Table IB. Evaluation Results for EL Inv-1 in Inv-23 and Inv-16**

| Sample | Inv-1 Wt %-Lum | Inv-23 Wt %-Non-Lum | Inv-16 Wt %-Non-Lum | Color CIEx,y* | Efficiency (cd/A)* | Drive Voltage (V)* | %Efficiency Increase vs Comp-5/8/9 | %Drive Voltage Decrease vs Comp- 8 |
|---|---|---|---|---|---|---|---|---|
| Cmp-5 | 0.4 | 80.0 | 19.6 | 0.634,0.360 | 3.04 | 8.7 | - | - |
| Cmp-6 | 0.4 | 72.2 | 27.4 | 0.638,0.356 | 3.44 | 8.7 | 13/50/72 | 3 |
| Cmp-7 | 0.3 | 66.7 | 33.0 | 0.638,0.355 | 3.67 | 7.9 | 21/60/84 | 12 |
| 4 | 0.3 | 56.0 | 43.7 | 0.637,0.355 | 3.91 | 7.5 | 29/71/96 | 17 |
| Cmp-8 | 0.5 | 99.5 | 0 | 0.567,0.401 | 2.29 | 9.0 | - | - |
| Cmp-9 | 0.5 | 0 | 99.5 | 0.624,0.362 | 2.00 | 5.5 | - | - |

| | | | | | | | | |
|---|---|---|---|---|---|---|---|---|
| * Measured at 20mA/cm² constant current | | | | | | | | |

The device characteristics detailed in Table IB differ from those of Table IA in that they cover a broader range of non-electroluminescent component ratios. Within the constraints of this example it is clear that sample 4 is the best device in terms of efficiency, color and drive voltage. As expected the operational drive voltage decreased continuously as the amount of Inv- 16 is increased in the LEL. The highest drive voltages are observed for those devices with the larger percentage of Inv-23 in the luminescent region, see Cmp-5 and 8.

### Example 3- EL Device Fabrication - Inventive Examples

### Sample Preparation and Testing

EL devices satisfying the requirements of the invention as Samples 5-8 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N*,*N*'-di-1-naphthalenyl-*N*,*N*'-diphenyl-4, 4'-diaminobiphenyl (NPB) having a thickness of 75 nm was then evaporated from a tantalum boat.
   c) A 37.5-74.3 nm LEL comprised of tris(8-quinolinolato)aluminum (III) **(Inv-23**, 0-99.5 wt %) , 9,10,11,12-tetraphenylnaphthacene **(Inv-16,** 0-99.5 wt%) and emitter-electroluminescent component, **Inv-1**, (0.30-0.50 wt %) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table IC.

**Table IC. Evaluation Results for EL Inv-1 in Inv-23 and Inv-16**

| Sample | Inv-1 Wt % | Inv-23 Wt % | Inv-16 Wt % | Color CIEx,y* | Efficiency (cd/A)* | Drive Voltage (V)* | %Efficiency Increase vs Cmp-10/11 | %Drive Voltage Decrease vs Cmp-10 |
|---|---|---|---|---|---|---|---|---|
| 5 | 0.3 | 57.0 | 42.7 | 0.648,0.348 | 3.24 | 8.0 | 90/119 | 5 |
| 6 | 0.3 | 53.9 | 45.8 | 0.648,0.347 | 3.48 | 7.8 | 104/135 | 7 |
| 7 | 0.3 | 52.9 | 47.6 | 0.648,0.347 | 3.40 | 7.9 | 99/130 | 6 |
| 8 | 02 | 50.9 | 48.9 | 0.649,0.347 | 3.40 | 7.8 | 99/130 | 7 |
| Cmp-10 | 0.5 | 99.5 | 0 | 0.583,0.386 | 1.71 | 8.4 | - | - |
| Cmp-11 | 0.5 | 0 | 99.5 | 0.636,0.351 | 1.48 | 5.6 | - | - |

| | | | | | | | | |
|---|---|---|---|---|---|---|---|---|
| * Measured at 20mA/cm² constant current | | | | | | | | |

Table IC is a continuation of the investigation presented in Table IB and further explores the non-electroluminescent component mixture-ratio regime for Inv-23 and 16. The comparative examples are comprised of a single non-electroluminescent component in the emissive layer, see Cmp-10, 11. Samples 5-8, explore the Inv-16 wt% regime from 42.7-99.5% and are significantly improved, in color, efficiency and drive voltage *vs* Cmp-11) relative to comparative data shown for Cmp-10, 11. It is interesting to note that there is not much difference between samples 5-8 and only a marginal difference between sample 5 and sample group 6-8.

### Example 4- EL Device Fabrication - Inventive Examples

### Sample Preparation and Testing

EL devices satisfying the requirements of the invention as Samples 9-11 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N'*-di-1-naphthalenyl-*N,N'-*diphenyl-4, 4'-diaminobiphenyl (NPB) having a thickness of 75 nm was then evaporated from a tantalum boat.
   c) A 37.5-75.4 nm LEL comprised of tris(8-quinolinolato)aluminum (III) **(Inv-23,** 0-57.85wt %), 9,10,11,12-tetraphenylnaphthacene (**Inv-16**, 41.85-99.5 wt %) and emitter-electroluminescent component, **Inv-1,** (0.50 wt %) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table ID

**Table ID. Evaluation Results for EL Inv-1 in Inv-23 and Inv-16**

| Sample | Inv-1 Wt% | Inv-23 Wt% | Inv-16 Wt% | Color CIEx,y* | Efficienc y (cd/A)* | Drive Voltage (V)* | %Efficiency Increase vs Cmp-12/13 | %Drive Voltage Decrease vs Cmp-12 |
|---|---|---|---|---|---|---|---|---|
| 9 | 0.2 | 49.9 | 49.9 | 0.645,0.348 | 3.97 | 7.1 | 15/70 | 0 |
| 10 | 0.3 | 50 | 49.7 | 0.646,0.348 | 3.88 | 6.9 | 13/66 | 3 |
| 11 | 0.2 | 50.7 | 49.1 | 0.646,0.347 | 3.84 | 7.0 | 11/64 | 1 |
| Cmp-12 | 0.3 | 57.8 | 41.9 | 0.647,0.346 | 3.45 | 7.1 | - | - |
| Cmp-13 | 0.5 | 0 | 99.5 | 0.632,0.356 | 2.34 | 6.0 | - | - |
| Cmp-14 | 0.5 | 0 | 99.5 | 0.632,0.356 | 2.17 | 6.1 | - | - |

| | | | | | | | | |
|---|---|---|---|---|---|---|---|---|
| * Measured at 20mA/cm² constant current | | | | | | | | |

The data in Table ID is a further continuation of wt %-space exploration for the mixed non-electroluminescent component system employing Inv-23 and 16 with Inv-1. Here the most salient point is that the differences in luminance efficiency, drive voltage and chromaticity are marginal. In fact samples 9-11 exhibit comparable performance to samples 6-8.

### TABLE II: A mixture of non-electroluminescent component of tris-(8-quinolinato)aluminum(III), [Inv-23] and Invention 17 with Invention 1.

### Example 5- EL Device Fabrication - Inventive Examples

### Sample Preparation and Testing

EL devices satisfying the requirements of the invention as Sample 12 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N'*-di-1-naphthalenyl-*N,N'-*diphenyl-4, 4'-diaminobiphenyl (NPB) having a thickness of 75 nm was then evaporated from a tantalum boat.
   c) A 37.5-66.9 nm LEL comprised of tris(8-quinolinolato)aluminum (III) (**Inv-23**, 0-99.5 wt%), 9,10,11,12-tetra-(2-naphthyl)naphthacene **(Inv-17,** 0-99.5 wt%) and emitter-electroluminescent component, **Inv-1,** (0.30-0.50wt%) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table II.

**Table II. Evaluation Results for EL Inv-1 in Inv-23 and Inv-17**

| Sample | Inv-1 Wt% | Inv-23 Wt% | Inv-17 Wt% | Color CIEx,y* | Efficiency (cd/A)* | Drive Voltage (V)* | %Efficiency Increase vs Cmp-15/19 | %Drive Voltage Decrease *vs* Cmp-15 |
|---|---|---|---|---|---|---|---|---|
| Cmp-15 | 0.5 | 99.5 | 0 | 0.576,0.388 | 1.45 | 7.7 | - | - |
| Cmp-16 | 0.4 | 80.8 | 18.8 | 0.642,0.351 | 2.15 | 7.2 | 48/7 | 7 |
| Cmp-17 | 0.4 | 72.8 | 26.8 | 0.643,0.349 | 2.50 | 7.1 | 72/24 | 8 |
| Cmp-18 | 0.3 | 66.9 | 32.8 | 0.641,0.350 | 2.61 | 6.8 | 80/30 | 12 |
| 12 | 0.3 | 56.9 | 42.8 | 0.639,0.352 | 2.65 | 6.7 | 83/32 | 13 |
| Cmp-19 | 0.5 | 0 | 99.5 | 0.621,0.363 | 2.01 | 5.0 | - | - |

| | | | | | | | | |
|---|---|---|---|---|---|---|---|---|
| * Measured at 20mA/cm² constant current | | | | | | | | |

The device described in example 5 and the data in Table II is related to the devices in Examples 1-4 except that the naphthacene Inv-16 is substituted by Inv-17. Again the comparative examples, Cmp-15 and 19, employ the single non-electroluminescent components Inv-23 and Inv-17, respectively, for electroluminescent component Inv-1. The 1.45 cd/A and 2.01 cd/A luminance efficiencies are observed for Cmp-15 and 19, respectively, are typical and consistent.

There is a clear improvement in the operational drive voltage for sample 12 relative to Cmp-15. Increasing the naphthacene, Inv-17,
wt % composition of the LEL results in progressively lower operational drive voltages along with improvements in luminance efficiency (i.e., 30-83 %) and chromaticity.

### TABLE III: A mixture of non-electroluminescent component of Invention 20 and Invention 16 with Invention 1.

### Example 6- EL Device Fabrication - Inventive Examples

### Sample Preparation and Testing

EL devices satisfying the requirements of the invention as Sample 13 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N*,*N*'-di-1-naphthalenyl-*N*,*N*'-diphenyl-4, 4'-diaminobiphenyl (NPB) having a thickness of 75 nm was then evaporated from a tantalum boat.
   c) A 37.5-66.2 nm LEL comprised of 9,10-di(4-tertbutylphenyl)naphthacene **(Inv-20,** 0-99.5 wt%), 9,10,11,12-tetraphenylnaphthacene (**Inv-16**, 0-99.5 wt %) and emitter-electroluminescent component, **Inv-1**, (0.20-0.50 wt %) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table III.

**Table III. Evaluation Results for EL Inv-1 in Inv-20 and Inv-16**

| Sample | Ins- 1 Wt% | Inv-20 Wt% | Inv-16 Wt% | Color CIEx,y* | Efficiency (cd/A)* | Drive Voltage (V)* | %Efficiency Increase *vs* Cmp-20/24 | %Drive Voltage Decrease *vs* Cmp-20 |
|---|---|---|---|---|---|---|---|---|
| Cmp-20 | 0.5 | 99.5 | 0 | 0.581,0.396 | 2.04 | 5.5 | - | - |
| Cmp-21 | 0.5 | 80 | 19.5 | 0.601,0.384 | 2.60 | 5.9 | 28/30 | - |
| Cmp-22 | 0.4 | 70.9 | 29.7 | 0.607,0.381 | 3.03 | 6.2 | 49/52 | - |
| Cmp-23 | 0.3 | 65.8 | 33.9 | 0.610,0.376 | 2.65 | 5.7 | 30/33 | - |
| 13 | 0.2 | 56.8 | 43.0 | 0.618,0.371 | 3.12 | 6.4 | 53/56 | - |
| Cmp-24 | 0.5 | 0 | 99.5 | 0.634,0.353 | 2.00 | 5.2 | - | - |

| | | | | | | | | |
|---|---|---|---|---|---|---|---|---|
| * Measured at 20mA/cm² constant current | | | | | | | | |

In this example the two non-electroluminescent components employed in the EML with Inv-1 are naphthacenes. Again, the comparative examples Cmp-20 and 24 are each comprised of a single non-electroluminescent component with the electroluminescent component Inv-1.

In this example there is no improvement in the operational drive voltage relative to the comparative examples because the electroluminescent layer is comprised of naphthacenes. However, sample 13 does exhibit decreased operational drive voltages when compared to Cmp-15 or sample 12.

Again, the luminance efficiency improves significantly upon mixing the two non-electroluminescent components. Sample 13 with 56.8 wt % of Inv-20 and 43 wt % of Inv-16 yield a device with the most improved efficiency relative to Cmp-20 and 24.

### TABLE IV: A mixture of non-electroluminescent component of tris-(8-quinolinato)aluminum(III), [Inv-23] and 2-t-butyl-9,10-di-(2-naphthyl)anthracene, [Inv-19] with Invention 1.

### Example 7- EL Device Fabrication - Comparative Examples

### Sample Preparation and Testing

EL devices as Comparatives (Cmp) were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N'*-di-1-naphthalenyl-*N,N'-*diphenyl-4, 4'-diaminobiphenyl (NPB) having a thickness of 75 nm was then evaporated from a tantalum boat.
   c) A 37.5-68.1 nm LEL comprised of tris(8-quinolinolato)aluminum (III) **(Inv-23,** 0-99.5 wt%) , 2-*tert*-butyl-9,10-di-(2-naphthyl)anthracene **(Inv-19,** 0-99.5 wt %) and emitter-electroluminescent component, **Inv-1,** (0.30-0.50 wt %) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table IV.

**Table IV. Evaluation Results for EL Inv-1 in Inv-23 and Inv-19**

| Sample | Inv-1 Wt% | Inv-23 Wt% | Inv-19 Wt% | Color CIEx,y* | Efficiency (cd/A)* | Drive Voltage (V)* | %Efficiency Increase | %Drive Voltage Decrease |
|---|---|---|---|---|---|---|---|---|
| Cmp-25 | 0.5 | 99.5 | 0 | 0.559,0.402 | 1.13 | 8.7 | - | - |
| Cmp-26 | 0.4 | 79.2 | 20.4 | 0.585,0.387 | 1.17 | 10.3 | - | - |
| Cmp-27 | 0.4 | 72.6 | 27.0 | 0.588,0.385 | 1.26 | 10.5 | - | - |
| Cmp-28 | 0.3 | 65.6 | 34.1 | 0.588,0.385 | 1.31 | 10.9 | - | - |
| Cmp-29 | 0.3 | 55.7 | 44.0 | 0.592,0.384 | 1.55 | 11.5 | - | - |
| Cmp-30 | 0.5 | 0 | 99.5 | 0.560,0.398 | 1.53 | 9.9 | - | - |

| | | | | | | | | |
|---|---|---|---|---|---|---|---|---|
| * Measured at 20mA/cm² constant current | | | | | | | | |

The comparative examples employ the non-electroluminescent components Inv-23 and Inv-19 in an LEL with Inv-1. These comparative examples clearly demonstrate that low operational drive voltages, high luminance efficiency and good color are very dependent on the selection of suitable non-electroluminescent components for Inv-1. None of these comparative examples yield good values for these properties.

### TABLE VA-VB: A mixture of non-electroluminescent component of 2-t-butyl-9,10-di-(2-naphthyl)anthracene, [Inv-19] and Invention 16 with Invention 1.

### Example 8- EL Device Fabrication - Inventive Examples

### Sample Preparation and Testing

EL devices satisfying the requirements of the invention as Sample 22-25 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N*,*N*'-di-1-naphthalenyl-*N*,*N*'-diphenyl-4, 4'-diaminobiphenyl (NPB) having a thickness of 75 nm was then evaporated from a tantalum boat.
   c) A 20-36.1 nm LEL comprised of 9,10,11,12-tetraphenylnaphthacene (**Inv-16**, 0-99.5 wt%), 2-*tert*-butyl-9,10-di-(2-naphthyl)anthracene (**Inv-19**, 0-99.5 wt%) and emitter-electroluminescent component, **Inv-1**, (0.20-0.50 wt%) were then deposited onto the hole-transporting layer. These materials were also evaporated from tantalum boats.
   d) A 55 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table VA.

**Table VA. Evaluation Results for EL Inv-1 in Inv-19 and Inv-16**

| Sample | Inv-1 Wt % | Inv-19 Wt % | Inv-16 Wt % | Color CIEx,y* | Efficiency (cd/A)* | Drive Voltage (V)* | %Efficiency Increase *vs* Comp-31/34 | %Drive Voltage Decrease vs Comp- 31 |
|---|---|---|---|---|---|---|---|---|
| Cmp-31 | 0.5 | 99.5 | 0 | 0.417,0.302 | 1.77 | 7.0 | - | - |
| Cmp-32 | 0.4 | 79.8 | 19.8 | 0.587,0.391 | 2.82 | 5.5 | 59/64 | 21 |
| Cmp-33 | 0.4 | 72.3 | 27.3 | 0.596,0.385 | 3.07 | 5.3 | 74/79 | 24 |
| 14 | 0.3 | 65.5 | 34.2 | 0.605,0.381 | 3.25 | 5.1 | 84/89 | 27 |
| 15 | 02 | 55.7 | 44.1 | 0.608,0.378 | 3.29 | 5.1 | 86/91 | 27 |
| Cmp-34 | 0.5 | 0 | 99.5 | 0.622,0.363 | 1.72 | 5.3 | - | - |

| | | | | | | | | |
|---|---|---|---|---|---|---|---|---|
| * Measured at 20mA/cm² constant current | | | | | | | | |

These examples employ the non-electroluminescent components Inv-19 and Inv-16 in the LEL with Inv-1. Again, the comparative examples Cmp-31 and 34 are devices that employ a single non-electroluminescent component with electroluminescent component Inv-1. This data clearly shows the advantage of mixing the two non-electroluminescent materials in the LEL.

Relative to Cmp-31, samples 14, 15 exhibit significant (27%) decreases in operational drive voltages.

Again, the luminance efficiency improved significantly upon mixing of the two non-electroluminescent components. The luminance increased by as much as 86 and 91 % versus Cmp-31 and 34 respectively. These luminance enhancements came while improving color purity as evidenced by the improved color coordinates.

### Example 9- EL Device Fabrication - Inventive Examples

### Sample Preparation and Testing

EL devices satisfying the requirements of the invention as Samples 16-19 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N*'-di-1-naphthalenyl-*N,N'-*diphenyl-4, 4'-diaminobiphenyl (NPB) having a thickness of 75 nm was then evaporated from a tantalum boat.
   c) A 20-39.5 nm LEL comprised of 9,10,11,12-tetraphenylnaphthacene **(Inv-16,** 0-99.5 wt%), 2-*tert*-butyl-9,10-di-(2-naphthyl)anthracene **(Inv-19,** 0-99.5 wt%) and emitter-electroluminescent component, **Inv-1,** (0.20-0.50 wt%) were then deposited onto the hole-transporting layer. These materials were also evaporated from tantalum boats.
   d) A 55 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table VB.

**Table VB. Evaluation Results for EL (Inv-1 in Inv-19 and Inv-16)**

| Sample | Inv-1 Wt % | Inv-19 Wt % | Inv-16 Wt % | Color CIEx,y* | Efficiency (cd/A)* | Drive Voltage (V)* | %Efficiency Increase *vs* Comp-35/36 | %Drive Voltage Decrease *vs* Comp-35 |
|---|---|---|---|---|---|---|---|---|
| Cmp-35 | 0.5 | 99.5 | 0 | 0.450,0.360 | 2.35 | 8.5 | - | - |
| 16 | 0.3 | 57.6 | 42.1 | 0.589,0.389 | 4.56 | 6.3 | 94/99 | 26 |
| 17 | 0.3 | 55.5 | 44.2 | 0.590,0.389 | 4.55 | 6.2 | 94/99 | 27 |
| 18 | 02 | 52.2 | 47.6 | 0.592,0.387 | 4.43 | 6.9 | 89/94 | 19 |
| 19 | 02 | 51.1 | 48.7 | 0.591,0.388 | 4.22 | 62 | 80/84 | 27 |
| Cmp-36 | 0.5 | 0 | 99.5 | 0.598,0.379 | 2.29 | 6.6 | - | - |

| | | | | | | | | |
|---|---|---|---|---|---|---|---|---|
| * Measured at 20mA/cm² constant current | | | | | | | | |

Table VB examines further the mixture-space for the non-electroluminescent components, Inv-19 and Inv-16, as employed in the LEL layer with Inv-1. Again, the comparative examples Cmp-35 and 36 are devices that employ a single non-electroluminescent component with electroluminescent component Inv-1. This data clearly shows the advantage of mixing the two non-electroluminescent materials in the LEL.

Relative to Cmp-35 all samples 16-19 exhibit significant (19-27%) decreases in operational drive voltages.

Again, the luminance efficiency improved significantly upon mixing of the two non-electroluminescent components. The luminance increased by as much as 94 and 99% versus Cmp-35 and 36, respectively. These luminance enhancements came while improving color purity as evidenced by the improved color coordinates particularly with respect to Cmp-35.

Finally, these results serve as further evidence that luminance, color and drive voltage are advantaged by mixing Inv-19 and 16 into the LEL with Inv-1.

### TABLE VI: A mixture of non-electroluminescent component of Invention 21 and Invention 16 with Invention 1.

### Example 10- EL Device Fabrication - Inventive Examples

### Sample Preparation and Testing constructed as Samples 20-22 and Comparatives

EL devices satisfying the requirements of the invention were in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N*,*N*'-di-1-naphthalenyl-*N*,*N*'-diphenyl-4, 4'-diaminobiphenyl (NPB) having a thickness of 75 nm was then evaporated from a tantalum boat.
   c) A 37.5 nm LEL comprised of 9,10,11,12-tetraphenylnaphthacene (**Inv-16**, 0-99.5 wt %), *N,N*'-di-1-naphthalenyl-NN'-diphenyl-4, 4'-diaminobiphenyl (NPB) (**Inv-21**, 0-99.5 wt %) and emitter-electroluminescent component, **Inv-1**, (0.30-0.50 wt %) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table VI.

**Table VI. Evaluation Results for EL (Inv-1 in Inv-21 and Inv-16)**

| Sample | Inv-1 Wt % | Inv-21 Wt % | Inv-16 Wt % | Color CIEx,y* | Efficiency (cd/A)* | Drive Voltage (V)* | %Efficiency Increase *vs* Comp-37,39 | %Drive Voltage Decrease |
|---|---|---|---|---|---|---|---|---|
| Cmp-37 | 0.5 | 99.5 | 0 | 0.477,0.445 | 2.13 | 6.3 | - | - |
| Cmp-38 | 0.4 | 79.1 | 20.5 | 0.620,0.370 | 2.44 | 6.7 | 15/64 | - |
| 20 | 0.4 | 65.6 | 34 | 0.628,0.364 | 2.73 | 6.6 | 28/83 | - |
| 21 | 0.3 | 53.6 | 46.1 | 0.632,0.361 | 2.93 | 6.4 | 38/97 | - |
| 22 | 0.3 | 50.9 | 48.8 | 0.632,0.361 | 2.95 | 6.5 | 39/98 | - |
| Cmp-39 | 0.5 | 0 | 99.5 | 0.635,0.353 | 1.49 | 5.6 | - | - |

| | | | | | | | | |
|---|---|---|---|---|---|---|---|---|
| * Measured at 20mA/cm² constant current | | | | | | | | |

Example 10 describes devices wherein the LEL is comprised of the two non-electroluminescent components Inv-21 and Inv-16 with Inv-1.

The luminance efficiency is significantly improved by 28-98 % relative to Cmp-37 and Cmp-39, respectively. Additionally, the color is advantaged for samples 20-22 relative to Cmp-37.

### TABLE VII: A mixture of non-electroluminescent components (Invention 19, 23 and 16 with Invention 1).

### Example 11- EL Device Fabrication - Inventive Examples

### Sample Preparation and Testing

EL devices satisfying the requirements of the invention as Sample 23 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N*'-di-1-naphthalenyl-*N,N'-*diphenyl-4, 4'-diaminobiphenyl (NPB) having a thickness of 75 nm was then evaporated from a tantalum boat.
   c) A 37.5-39.5 nm LEL comprised of 9,10,11,12-tetraphenylnaphthacene **(Inv-16,** 0-99.5 wt%), Compacted pellet of (50 wt% 2-*tert*-butyl-9,10-di-(2-naphthyl)anthracene and 50 wt% tris(8-quinolinolato)aluminum (III) **(Inv-19 and Inv-23,** 0-99.5 wt%) and emitter-electroluminescent component, **Inv-1**, (0.20-50 wt%) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table VI.

**Table VII. Evaluation of EL (Inv-1 in Inv-19, 23 and 16)**

| Sample | Inv-1 Wt % | Inv-19 & Inv-23 Wt % | Inv-16 Wt % | Color CIEx,y* | Efficiency (cd/A)* | Drive Voltage (V)* | %Efficiency Increase *vs* Comp-40/44 | %Drive Voltage Decrease *vs* Comp-40 |
|---|---|---|---|---|---|---|---|---|
| Cmp-40 | 0.5 | 99.5 | 0 | 0.545,0.408 | 1.83 | 8.4 | - | - |
| Cmp-41 | 0.4 | 79.1 | 20.5 | 0.631,0.359 | 3.11 | 6.9 | 70/44 | 18 |
| Cmp-42 | 0.4 | 72.0 | 27.6 | 0.636,0.356 | 3.48 | 6.9 | 90/61 | 18 |
| Cmp-43 | 0.3 | 67.9 | 31.8 | 0.639,0.353 | 3.77 | 6.7 | 106/75 | 20 |
| 23 | 0.3 | 57.4 | 42.3 | 0.640,0.353 | 4.21 | 6.2 | 130/95 | 26 |
| Cmp-44 | 0.5 | 0 | 99.5 | 0.636,0.354 | 2.16 | 5.6 | - | - |

| | | | | | | | | |
|---|---|---|---|---|---|---|---|---|
| * Measured at 20mA/cm² constant current | | | | | | | | |

The data in Table VII describes the performance characteristics of Example 11. This example employs a ternary non-electroluminescent component system for Inv-1. Comparative example Cmp-29, is a mixture of 56 wt % Inv-19 and 44 wt% Inv-23 and its performance is very similar to Cmp-40. Comparative example Cmp-44, is comprised of only the one non-electroluminescent component Inv-16.

The operational drive voltage for sample 23 is advantaged by 26% over Cmp-40.

The luminance efficiency for sample 23 is increased by as much as 130 and 95 % when compared to Cmp-40 and 44, respectively. This data is consistent with previous results where the luminance increases tracked with the larger percentages of Inv-16 in the LEL.

### TABLE VIIIA-C: A mixture of non-electroluminescent components Invention 23 and Invention 16 with Invention 9.

### Example 12- EL Device Fabrication - Inventive Examples

### Sample Preparation and Testing

EL devices satisfying the requirements of the invention as Sample 24 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N*,*N*'-di-1-naphthalenyl-*N*,*N*'-diphenyl-4, 4'-diaminobiphenyl (NPB) having a thickness of 75 nm was then evaporated from a tantalum boat.
   c) A 37.5-66.3 nm LEL comprised of 9,10,11,12-tetraphenylnaphthacene (**Inv-16**, 0-99 wt %), tris(8-quinolinolato)aluminum (III) (**Inv-23**, 0-99 wt%) and emitter-electroluminescent component, **Inv-9**, (0.6-1.0 wt%) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table VIIIA.

**Table VIIIA. Evaluation of EL (Inv-9 in Inv-23 and 16)**

| Sample | Inv-9 Wt % | Inv-23 Wt % | Inv-16 Wt % | Color CIEx,y* | Efficiency (cd/A)* | Drive Voltage (V)* | %Efficiency Increase *vs* Comp-31,32 | %Drive Voltage Decrease *vs* Comp-31 |
|---|---|---|---|---|---|---|---|---|
| Cmp-45 | 1 | 99 | 0 | 0.625,0.368 | 2.16 | 9.1 | - | - |
| Cmp-46 | 0.9 | 94.4 | 4.7 | 0.643,0.354 | 2.37 | 9.0 | 10/179 | 1 |
| Cmp-47 | 0.9 | 89.2 | 9.9 | 0.645,0.352 | 2.84 | 8.7 | 32/234 | 4 |
| Cmp-48 | 0.7 | 66 | 33.3 | 0.641,0.355 | 4.43 | 7.4 | 105/421 | 19 |
| 24 | 0.6 | 56.8 | 42.6 | 0.636,0.359 | 4.76 | 7.3 | 120/460 | 20 |
| Cmp-49 | 1 | 0 | 99 | 0.547,0.428 | 0.85 | 5.5 | - | - |

| | | | | | | | | |
|---|---|---|---|---|---|---|---|---|
| *Measured at 20mA/cm² constant current | | | | | | | | |

The comparative examples Cmp-45 and 49 employ a single non-electroluminescent component Inv-23 and Inv-16, respectively. Samples 24 and Cmp-46-48 are each comprised of a different ratio of the two non-electroluminescent components in the LEL with Inv-9.

The operational drive voltages for sample 24 was improved by about 20 %.

The mixture of non-electroluminescent components comprising sample 24 provided increases as large as 120 and 460 % in luminance efficiency relative to Cmp-45 and 49, respectively. These improvements in luminance were obtained in conjunction with good chromaticity.

### Example 13- EL Device Fabrication - Inventive Examples

### Sample Preparation and Testing

EL devices satisfying the requirements of the invention as Sample 25 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N*'-di-1-naphthalenyl-*N,N'-*diphenyl-4, 4'-diaminobiphenyl (NPB) having a thickness of 75 nm was then evaporated from a tantalum boat.
   c) A 37.5-65.5 nm LEL comprised of 9,10,11,12-tetraphenylnaphthacene (**Inv-16**, 0-99 wt %), tris(8-quinolinolato)aluminum (III) (**Inv-23**, 0-99 wt %) and emitter-electroluminescent component, **Inv-9**, (0.60-1.0 wt %) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table VIIIB.

**Table VIIIB. Evaluation of EL (Inv-9 in Inv-23 and 16)**

| Sample | Inv-9 Wt % | Inv-23 Wt % | Inv-16 Wt % | Color CIEx,y* | Efficiency (cd/A)* | Drive Voltage (V)* | %Efficiency Increase *vs* Comp-33,34 | %Drive Voltage Decrease *vs* Comp-34 |
|---|---|---|---|---|---|---|---|---|
| Cmp-50 | 1 | 99 | 0 | 0.629,0.365 | 2.02 | 9.8 | - | - |
| Cmp-51 | 0.8 | 79.0 | 20.2 | 0.646,0.351 | 3.62 | 7.8 | 79/364 | 20 |
| Cmp-52 | 0.7 | 72.7 | 26.6 | 0.643,0.354 | 4.39 | 7.0 | 117/463 | 29 |
| Cmp-53 | 0.7 | 66.1 | 33.2 | 0.640,0.356 | 4.48 | 7.4 | 122/474 | 25 |
| 25 | 0.6 | 57.2 | 42.2 | 0.634,0.362 | 4.46 | 6.8 | 121/472 | 31 |
| Cmp-54 | 1 | 0 | 99 | 0.540,0.436 | 0.78 | 5.5 | - | - |

| | | | | | | | | |
|---|---|---|---|---|---|---|---|---|
| *Measured at 20mA/cm² constant current | | | | | | | | |

The comparative examples Cmp-50 and 54 employ the single non-electroluminescent component Inv-23 or Inv-16, respectively. Sample 25 and Cmp-51-53 are each comprised of a different ratio of the two non-electroluminescent components in the LEL with Inv-9.

The operational drive voltage for the sample 25 is improved. By 31 % vs. Cmp-50. This improvement in luminance was obtained in conjunction with good chromaticity.

### Example 14- EL Device Fabrication - Inventive Examples

### Sample Preparation and Testing

EL devices satisfying the requirements of the invention as Sample 26-29 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N'*-di-1-naphthalenyl-*N,N'*- diphenyl-4, 4'-diaminobiphenyl (NPB) having a thickness of 75 nm was then evaporated from a tantalum boat.
   c) A 37.5-66.5 nm LEL comprised of 9,10,11,12-tetraphenylnaphthacene (**Inv-16**, 9-43 wt %), tris(8-quinolinolato)aluminum (III) (**Inv-23**, 56-90 wt %) and emitter-electroluminescent component, **Inv-9**, (0.6-0.9 wt %) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table VIIIC.

**Table VIIIC. Evaluation of EL (Inv-9 in Inv-23 and 16)**

| Sample | Inv-9 Wt % | Inv-23 Wt % | Inv-16 Wt % | Color CIEx,y* | Efficiency (cd/A)* | Drive Voltage (V)* | %Efficiency Increase *vs* Comp-55 | %Drive Voltage Decrease *vs* Comp-55 |
|---|---|---|---|---|---|---|---|---|
| Cmp-55 | 0.7 | 65.9 | 33.4 | 0.640,0.357 | 5.01 | 7.7 | 77 | 11 |
| 26 | 0.6 | 64.4 | 35 | 0.639,0.357 | 5.31 | 7.3 | 88 | 15 |
| 27 | 0.6 | 59.6 | 39.8 | 0.637,0.359 | 5.21 | 7.5 | 85 | 13 |
| 28 | 0.6 | 58.5 | 40.9 | 0.635,0.361 | 5.26 | 7.2 | 87 | 16 |
| 29 | 0.6 | 56.2 | 43.2 | 0.635,0.360 | 4.65 | 6.6 | 65 | 23 |
| Cmp-56 | 0.9 | 90.2 | 8.9 | 0.644,0.353 | 2.82 | 8.6 | - | - |

| | | | | | | | | |
|---|---|---|---|---|---|---|---|---|
| * Measured at 20mA/cm² constant current | | | | | | | | |

The comparative example Cmp-56 employs a non-electroluminescent component containing a small wt % of the naphthacene Inv-16. Samples 26-29 are each comprised of a different ratio of the two non-electroluminescent components in the LEL with Inv-9.

The operational drive voltages for the samples 26-29 are improved by 15 % for the smallest wt % of Inv-16 and by 23 % for sample 29 which has 43.2 wt % of Inv-16 in the LEL.

The mixture of non-electroluminescent components comprising samples 26-29 provided increases in luminance efficiency relative to Cmp-56 ranging from 65-88 %. These improvements in luminance were obtained in conjunction with good red color.

### TABLE IX: A mixed non-electroluminescent component of Invention 23 and Invention 17 with Invention 9.

### Example 15- EL Device Fabrication - Inventive Examples

### Sample Preparation and Testing

EL devices satisfying the requirements of the invention as Sample 30 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N*,*N*'-di-1-naphthalenyl-*N*,*N*'-diphenyl-4, 4'-diaminobiphenyl (NPB) having a thickness of 75 nm was then evaporated from a tantalum boat.
   c) A 37.5-66.5 nm LEL comprised of 9,10,11,12-tetra(2-napahthyl)naphthacene **(Inv-17,** 0-99 wt %), tris(8-quinolinolato)aluminum (III) (**Inv-23**, 0-99 wt %) and emitter-electroluminescent component, **Inv-9**, (0.6-1.0 wt %) were then deposited onto the hole-transporting layer. These materials were also evaporated from tantalum boats.
   d) A 37.5 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table IX.

**Table IX. Evaluation of EL (Inv-9 in Inv-23 and 17)**

| Sample | Inv-9 Wt % | Inv-23 Wt % | Inv-17 Wt % | Color CIEx,y* | Efficiency (cd/A)* | Drive Voltage (V)* | %Efficiency Increase *vs* Comp-57/61 | %Drive Voltage Decrease *vs* Comp-57 |
|---|---|---|---|---|---|---|---|---|
| Cmp-57 | 1 | 99 | 0 | 0.618,0.375 | 2.40 | 8.7 | - | - |
| Cmp-58 | 0.8 | 79 | 20.2 | 0.637,0.360 | 2.94 | 7.9 | 23/92 | 9 |
| Cmp-59 | 0.7 | 71.6 | 27.7 | 0.635,0.361 | 3.23 | 7.6 | 35/111 | 13 |
| Cmp-60 | 0.7 | 66.4 | 32.9 | 0.633,0.363 | 3.19 | 7.5 | 33/109 | 14 |
| 30 | 0.6 | 56.5 | 42.9 | 0.626,0.369 | 3.18 | 7.4 | 33/108 | 15 |
| Cmp-61 | 1 | 0 | 99 | 0.565,0.418 | 1.53 | 5.1 | - | - |

| | | | | | | | | |
|---|---|---|---|---|---|---|---|---|
| *Measured at 20mA/cm² constant current | | | | | | | | |

The comparative examples Cmp-57 and 61 employ the single non-electroluminescent component Inv-23 or Inv-17, respectively. Sample 30 and Cmps 58-60 are each comprised of a different ratio of the two non-electroluminescent components in the LEL with Inv-9.

The operational drive voltages for sample 30 is improved by up to 15%.

The mixture of non-electroluminescent components comprising sample 30 provided increases as large as 33 and 108 % in luminance efficiency relative to Cmp-57 and 61, respectively. These improvements in luminance were obtained in conjunction with good red chromaticity.

### TABLE X: A mixed non-electroluminescent component (50 wt % Invention 19 and 50 wt % Invention 23) and Invention 16 with Invention 9.

### Example 16- EL Device Fabrication - Inventive Examples

### Sample Preparation and Testing

EL devices satisfying the requirements of the invention as Sample 31 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N'*-di-1-naphthalenyl-*N,N'-*diphenyl-4, 4'-diaminobiphenyl (NPB) having a thickness of 150 nm was then evaporated from a tantalum boat.
   c) A 350 nm LEL comprised of 9,10,11,12-tetraphenylnaphthacene (**Inv-16**, 0-49.1 wt%), Compacted pellet of 50 wt% 2-*tert*-butyl-9,10-di-(2-naphthyl)anthracene and 50 wt% tris(8-quinolinolato)aluminum (III) (**Inv-19 and Inv-23**, 48.9-98 wt%) and emitter-electroluminescent component, **Inv-9**, (2 wt%) were then deposited onto the hole-transporting layer. These materials were also evaporated from tantalum boats.
   d) A 350 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table X.

**Table X. Evaluation of EL (Inv-9 in Inv-19, 23 and 16)**

| Sample | Inv-1 Wt % | Inv-19 & Inv-23 Wt % | Inv-16 Wt % | Color CIEx,y* | Efficiency (cd/A)* | Drive Voltage (V)* | %Efficiency Increase *vs* Comp-62 | %Drive Voltage Decrease *vs* Comp-62 |
|---|---|---|---|---|---|---|---|---|
| Cmp-62 | 2 | 98 | 0 | 0.64,0.36 | 3.87 | 10.3 | - | - |
| Cmp-63 | 2 | 94 | 4 | 0.63,0.37 | 3.82 | 9.4 | - | 9 |
| Cmp-64 | 2 | 88.5 | 9.5 | 0.64,0.36 | 3.81 | 8.4 | - | 19 |
| Cmp-65 | 2 | 78.3 | 19.7 | 0.64,0.36 | 4.11 | 8.1 | 6 | 21 |
| Cmp-66 | 2 | 68.2 | 29.8 | 0.64,0.36 | 4.22 | 7.8 | 9 | 24 |
| 31 | 2 | 48.9 | 49.1 | 0.64,0.36 | 4.32 | 7.4 | 12 | 28 |

| | | | | | | | | |
|---|---|---|---|---|---|---|---|---|
| *Measured at 20mA/cm² constant current | | | | | | | | |

The comparative example Cmp-62 employs 98 wt % of the compacted pellet containing 50 wt % of each of the non-electroluminescent components Inv-23 and Inv-19. Sample 31 and Cmp- 63-66 are each comprised of a different ratio of the three non-electroluminescent components in the LEL with Inv-9.

The operational drive voltages for sample 31 is improved by 28 %.

The mixture of non-electroluminescent components comprising sample 31 provided increases of 12 % in luminance efficiency relative to Cmp-62.

These improvements in luminance were obtained in conjunction with good red color.

### TABLE XI: A mixed non-electroluminescent component (50 wt % Invention 19 and 50 wt % Invention 23) and DBZR, Inv-18 with Invention 9.

### Example 17- EL Device Fabrication - Inventive Examples

### Sample Preparation and Testing

EL devices satisfying the requirements of the invention as Sample 60-64 and Comparatives were constructed in the following manner:
A glass substrate coated with an 85 nm layer of indium-tin oxide (ITO) as the anode was sequentially ultrasonicated in a commercial detergent, rinsed in deionized water, degreased in toluene vapor and exposed to oxygen plasma for about 1 min.
   a) Over the ITO was deposited a 1 nm fluorocarbon (CFx) hole-injecting layer (HIL) by plasma-assisted deposition of CHF₃.
   b) A hole-transporting layer (HTL) of *N,N'*-di-1-naphthalenyl-*N,N'-*diphenyl-4, 4'-diaminobiphenyl (NPB) having a thickness of 150 nm was then evaporated from a tantalum boat.
   c) A 350 nm LEL comprised of 5,12-bis[2-(5-methylbenzothiazolyl)phenyl]-6,11-diphenylnaphthacene **(DBZR,** 0-90 wt%), Compacted pellet of 50 wt% 2-*tert*-butyl-9,10-di-(2-naphthyl)anthracene and 50 wt% tris(8-quinolinolato)aluminum (III) (**Inv-19 and Inv-23**, 8-98 wt%) and electroluminescent component, **Inv-9**, (2 wt%) were then deposited onto the hole-transporting layer. These materials were also evaporated from tantalum boats.
   d) A 350 nm electron-transporting layer (ETL) of tris(8-quinolinolato)aluminum (III) (Alq₃) was then deposited onto the light-emitting layer. This material was also evaporated from a tantalum boat.
   e) On top of the Alq₃ layer was deposited a 220 nm cathode formed of a 10:1 volume ratio of Mg and Ag.

The above sequence completed the deposition of the EL device. The device was then hermetically packaged in a dry glove box for protection against ambient environment.

The cells thus formed were tested for efficiency (in the form of luminance yield), color, drive voltage and the results are listed in Table XI.

**Table XI. Evaluation of LEL (Inv-9 in Inv-19, 23 and 18)**

| Sample | Inv-1 Wt % | Inv-19 & Inv-23 Wt % | Inv-18 Wt % | Color CIEx,y* | Efficiency (cd/A)* | Drive Voltage (V)* | %Efficiency Increase *vs* Comp-67 | %Drive Voltage Decrease *vs* Comp-67 |
|---|---|---|---|---|---|---|---|---|
| Cmp-67 | 2 | 98 | 0 | 0.64,0.36 | 3.60 | 10.30 | - | - |
| Cmp-68 | 2 | 64.5 | 33.5 | 0.63,0.36 | 3.00 | 10.10 | - | 2 |
| 32 | 2 | 45 | 53 | 0.64,0.36 | 3.45 | 9.10 | - | 12 |
| 33 | 2 | 26.7 | 71.3 | 0.64,0.36 | 3.30 | 8.70 | - | 16 |
| 34 | 2 | 17.4 | 80.6 | 0.63,0.36 | 2.90 | 8.20 | - | 20 |
| 35 | 2 | 8 | 90 | 0.63,0.37 | 1.75 | 8.30 | - | 19 |

| | | | | | | | | |
|---|---|---|---|---|---|---|---|---|
| * Measured at 20mA/cm² constant current | | | | | | | | |

The comparative example Cmp-67 employs 98 wt % the compacted pellet containing 50 wt % of each of the electroluminescent components Inv-23 and Inv-19. Samples 32-35 are each comprised of a different ratio of the three non-electroluminescent components in the LEL with Inv-9.

The operational drive voltages for the samples 32-35 are improved by 20 %.

Embodiments of the invention include those where:
the OLED light emitting layer contains more than one electroluminescent component;
the non-electroluminescent component with the second bandgap is at least 40 weight percent of the total components in the light emitting layer;
the OLED wherein the electroluminescent component with the first bandgap is in the range of 0.1 to 5 or desirably 0.3 to 0.7 weight percent of the total components in the light emitting layer;
in formula (2), R₁, R₂, R₃, R₄, and R₅ are selected independently from the group consisting of hydrogen, alkyl and aryl groups or suitably wherein at least one of R₁, R₂, R₃, R₄, and R₅ is independently selected from the group consisting of halide, alkyl, aryl, alkoxy and aryloxy group;
the non-electroluminescent component with the second bandgap is present in an amount of at least 34 desirably at least 40, desirably in the range of 40-75 weight percent of the total components in the light emitting layer;
the electroluminescent component with the first bandgap is desired to be 0.1 to 5, desirably 0.5 to 1.5 , conveniently 1±0.2 weight percent of the total components in the light emitting layer; and
the OLED where the component of formula (3) wherein at least one of R₁, R₂, R₃, R₄, R₅, R₆, R₇, R₈, R₉, R₁₀, R₁₁, and R₁₂ are independently selected from the group consisting of halide, alkyl, aryl, alkoxy and aryloxy groups.

Also included are:
a white light emitting device comprising the OLED of claim 1.

A single colo, multicolor or whiter light emitting device comprising the OLED; a process for making an OLED device wherein the light emitting layer containing an electroluminescent component having a first bandgap and at least two non-electroluminescent components having second and further bandgaps, respectively are evaporated from compact pellet formed from a mixture of these components in a desired composition especially wherein the light emitting layer is formed by evaporating compacted pellets formed from a mixture of luminescent and/or non-luminescent components;
a method of making an organic layer from an organic material on a substrate which will form part of an organic light-emitting device, comprising the steps of
   a) forming a consolidated solid pellet from the powder mixture of the organicnon-electroluminescent component and/or organic electroluminescent material in a selected weight fraction;
   b) placing the pellet into a physical vapor deposition source disposed in a chamber;
   c) positioning the substrate in the vacuum chamber and in a spaced relationship with respect to the source; and
   d) applying heat to the source to cause a portion of the pellet to sublime to provide a vapor of the first mixture of organic materials from which the organic layer is made on the substrate;
an OLED device comprising;
   a) a substrate;
   b) an anode disposed over the substrate;
   c) a hole injecting layer disposed over the anode;
   d) a hole transport layer disposed over the hole injecting layer; and
   e) a light emitting layer containing an electroluminescent component having a first bandgap and at least two non-electroluminescent components having second and further bandgaps, as in claim 1;
   f) an electron transport layer disposed over the light emitting layer; and
   g) a cathode disposed over the electron transport layer;
an OLED device comprising a light emitting layer containing an electroluminescent component having a first bandgap and at least two non-electroluminescent components having second and further bandgaps, respectively, wherein:
   i) the second bandgap is equal to or greater than the first bandgap but is not more than 2.7 eV;
   ii) the further bandgaps are greater than the first and second bandgaps;
   iii) the non-electroluminescent component with the second bandgap is present in an amount of at least 10 weight percent of the total components in the light emitting layer;
   iv) the non-electroluminescent components with further bandgaps are present in a combined amount of 0.1 to 89.9 weight percent of the total components in the light emitting layer; and
   v) the electroluminescent component is a periflanthene compound and is present in amount of 0.1 to 5 weight percent of the total components in the light emitting layer;
an OLED device comprising a light emitting layer containing an electroluminescent component having a first bandgap and at least two non-electroluminescent components having second and further bandgaps, respectively, wherein:
   i) the second bandgap is equal to or greater than the first bandgap but is not more than 2.7 eV;
   ii) the further bandgaps are greater than the first and second bandgaps;
   iii) the non-electroluminescent component with the second bandgap is present in an amount of 10 to 89.9 weight percent of the total components in the light emitting layer;
   iv) the non-electroluminescent components with further bandgaps are present in a combined amount of 0.1 to 89.9 weight percent of the total components in the light emitting layer and is selected from 2,2',2"-(1,3,5-benzenetriyl)tris[1-phenyl-1H-benzimidazole] and 2-*tert*-butyl-9,10-di-(2-naphthyl)anthracene (TBADN); 5,6,11,12-tetraphenylnaphthacene (rubrene); *N,N'*-di-1-naphthalenyl-*N,N'*-diphenyl-4,4'-diaminobiphenyl (NPB); 5,12-bis[2-(5-methylbenzothiazolyl)phenyl]-6,11-diphenylnaphthacene (DBZR); 5,12-bis[4-*tert*-butylphenyl]naphthacene (tBDPN); and 5,6,11,12-tetra-2-naphthalenylnaphthacene; and
   v) the electroluminescent component is present in amount of 0.1 to 5 weight percent of the total components in the light emitting layer; and
an OLED device comprising a light emitting layer containing an electroluminescent component having a first bandgap a non-electroluminescent component having a second bandgap and at least two non-electroluminescent component having further bandgaps, wherein:
   i) the second bandgap is equal to or greater than the first bandgap but is not more than 2.7 eV;
   ii) each of the further bandgaps are greater than the first and second bandgaps;
   iii) the non-electroluminescent component with the second bandgap is present in an amount of 10 to 89.9 weight percent of the total components in the light emitting layer;
   iv) the at least two non-electroluminescent components having further bandgaps are present in a combined amount of 0.1 to 89.9 weight percent of the total components in the light emitting layer and at least one is selected from tris(8-quinolinolato)aluminum (III) (Alq₃); 2,2',2"-(1,3,5-benzenetriyl)tris[1-phenyl-1H-benzimidazole] and 2-*tert*-butyl-9,10-di-(2-naphthyl)anthracene (TBADN); 5,6,11,12-tetraphenylnaphthacene (rubrene); *N*,*N*'-di-1-naphthalenyl-*N*,*N*'-diphenyl-4, 4'-diaminobiphenyl (NPB); 5,12-bis[2-(5-methylbenzothiazolyl)phenyl]-6,11-diphenylnaphthacene (DBZR); 5,12-bis[4-*tert*-butylphenyl]naphthacene (tBDPN); and 5,6,11,12-tetra-2-naphthalenylnaphthacene.; and
   v) the electroluminescent component is present in amount of 0.1 to 5 weight percent of the total components in the light emitting layer.

## Claims

1. An OLED device comprising a light emitting layer containing an electroluminescent component having a first bandgap and at least two non-electroluminescent components having second and further bandgaps, respectively, wherein:
i) the second bandgap is equal to or greater than the first bandgap but is not more than 2.7 eV;
ii) the further bandgaps are greater than the first and second bandgaps;
iii) the non-electroluminescent component with the second bandgap is present in an amount of at least 34 weight percent of the total components in the light emitting layer;
iv) the non-electroluminescent components with further bandgaps are present in a combined amount of 0.1 to 65.9 weight percent of the total components in the light emitting layer; and
v) the electroluminescent component is present in amount of 0.1 to 5 weight percent of the total components in the light emitting layer.

2. The OLED of claim 1 wherein the electroluminescent component with the first bandgap is a periflanthene derivative represented by formula **(1)**: 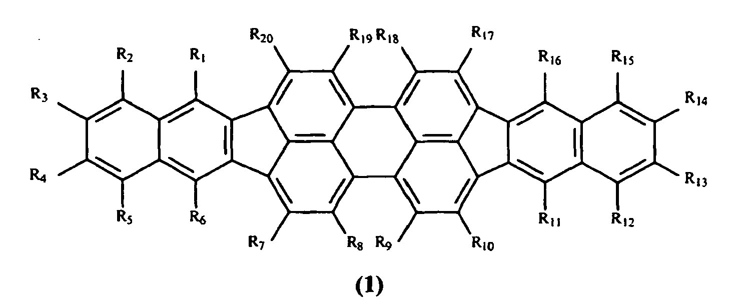 wherein:
R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀ are independently selected as hydrogen or substituents;
provided that any of the indicated substituents may join to form further fused rings.

3. The OLED of claim 2 wherein at least one R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀ are independently selected from the group consisting of halide, alkyl, aryl, alkoxy and aryloxy groups.

4. The OLED of claim 3 wherein at least one substituent is a phenyl group.

5. The OLED of claim 2 wherein the non-electroluminescent component with the second bandgap is desired to be in the range of 40 to 75 weight percent of the total components in the light emitting layer.

6. The OLED of claim 2 wherein the periflanthene compound is represented by one of the following formulas:

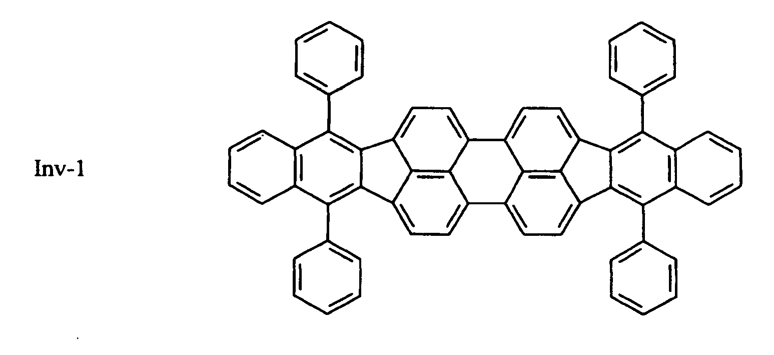

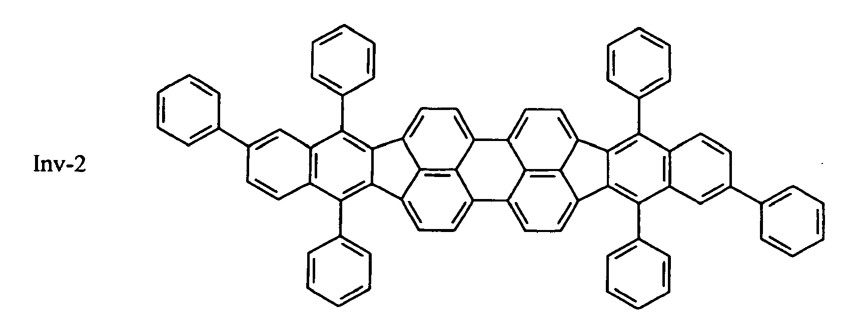

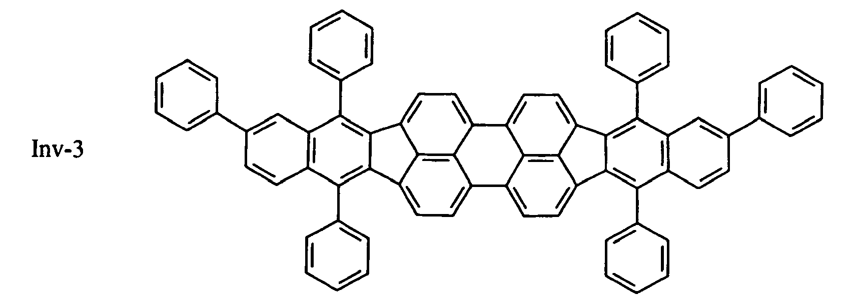

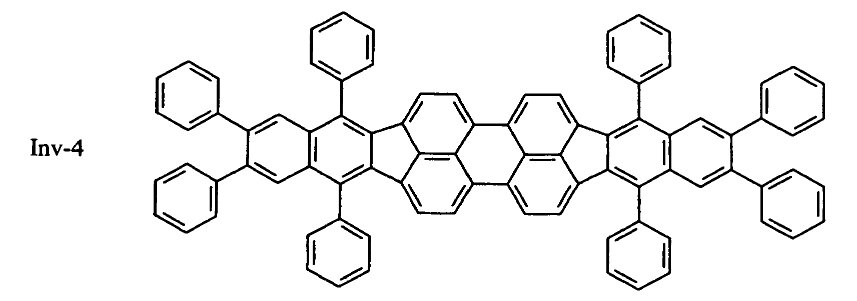

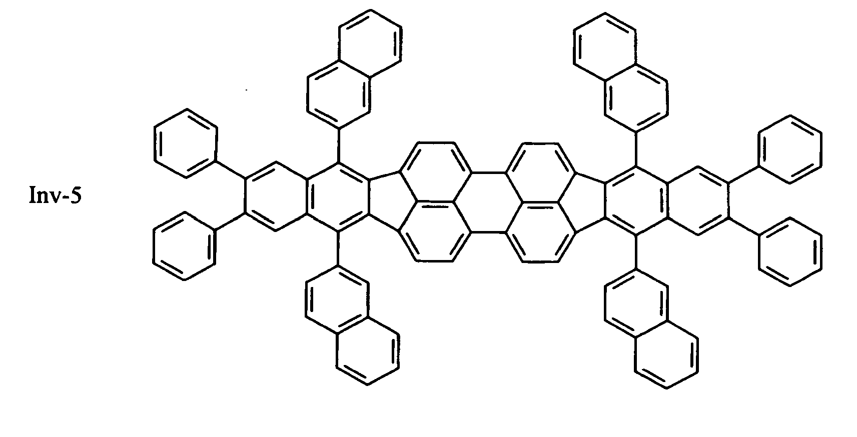

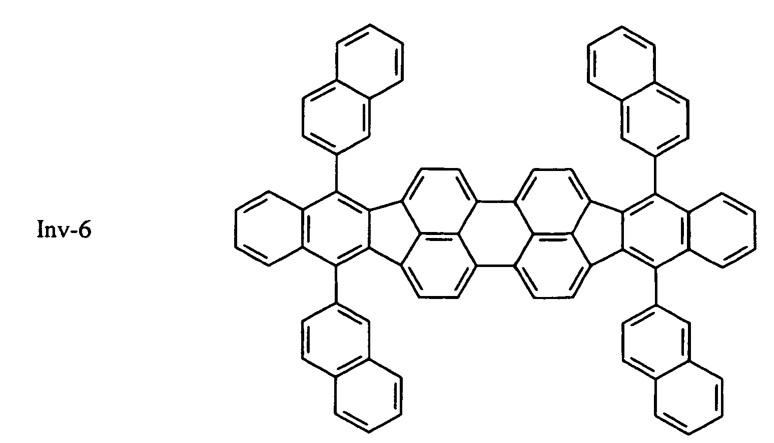

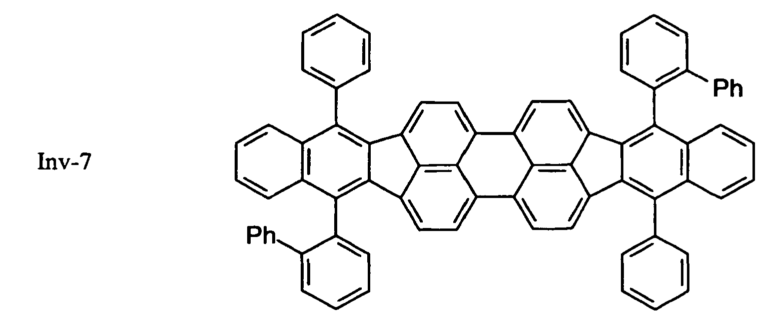

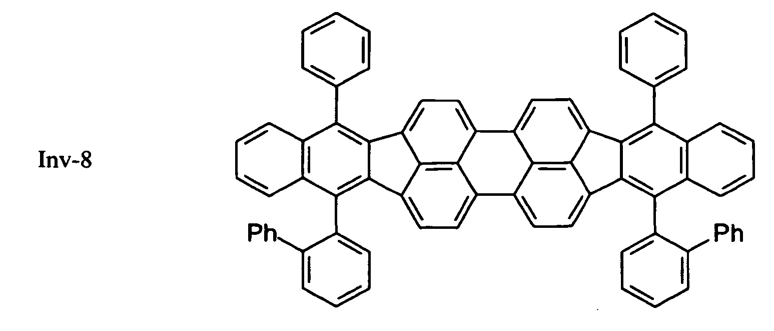

7. The OLED of claim 1 wherein the electroluminescent component with the first bandgap is a pyran derivative represented by formula **(2)**: 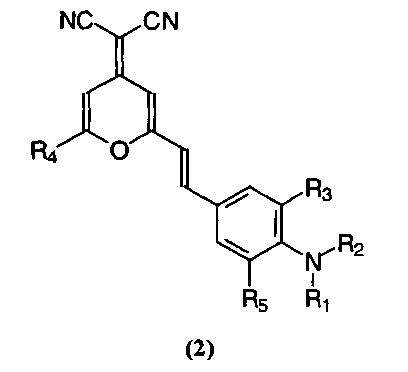 wherein:
R₁, R₂, R₃, R₄, and R₅ are independently selected as hydrogen or substituents;
provided that any of the indicated substituents may join to form further fused rings.

8. The device of claim 7 wherein the compound of formula **(2)** is represented by one of the following formulas:
| | |
|---|---|
| Inv-9 | 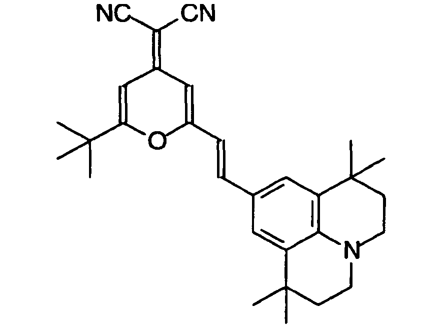 |
| Inv-10 | 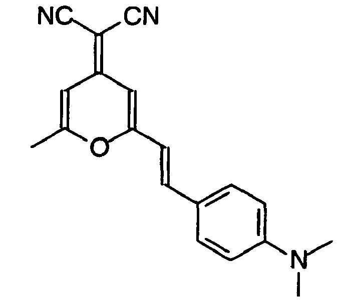 |
| Inv-11 | 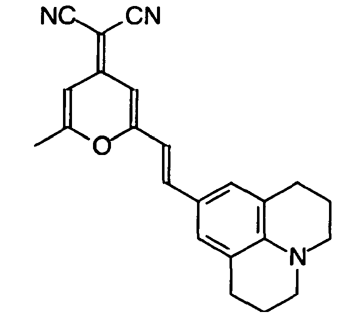 |
| Inv-12 | 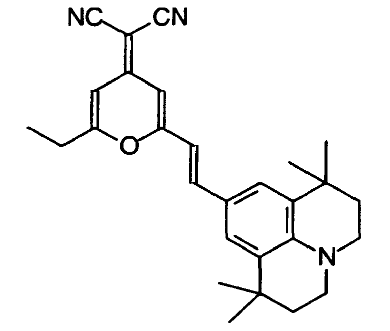 |
| Inv-13 | 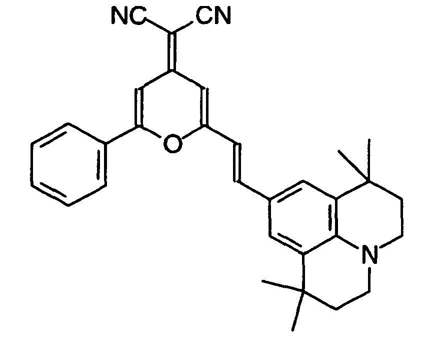 |
| Inv-14 | 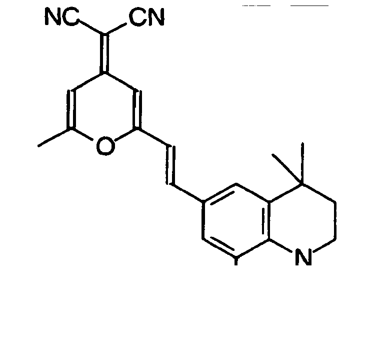 |
| Inv-15 | 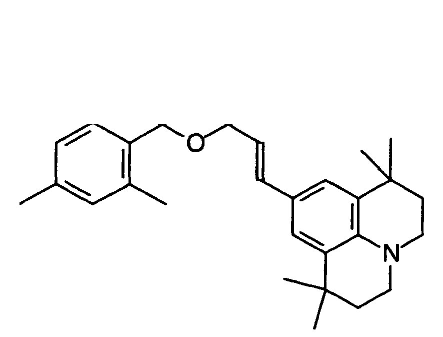 |

9. The device of claim 1 wherein the non-electroluminescent component with the second bandgap is a naphthacene represented by formula **(3)**: 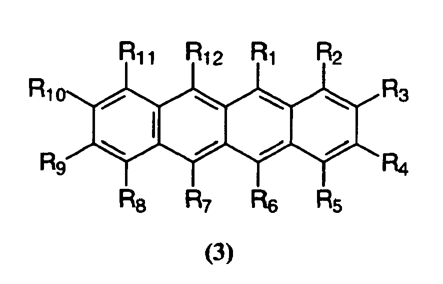 wherein:
R₁, R₂, R₃, R₄, R₅, R₆, R₇, R₈, R₉, R₁₀, R₁₁, and R₁₂ are independently selected as hydrogen or substituents;
provided that any of the indicated substituents may join to form further fused rings.

10. The device of claim 1 wherein the non-electroluminescent component with a further bandgap is selected from the following compounds:

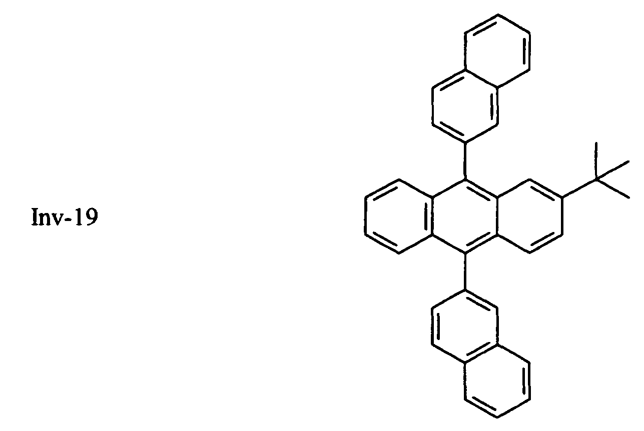

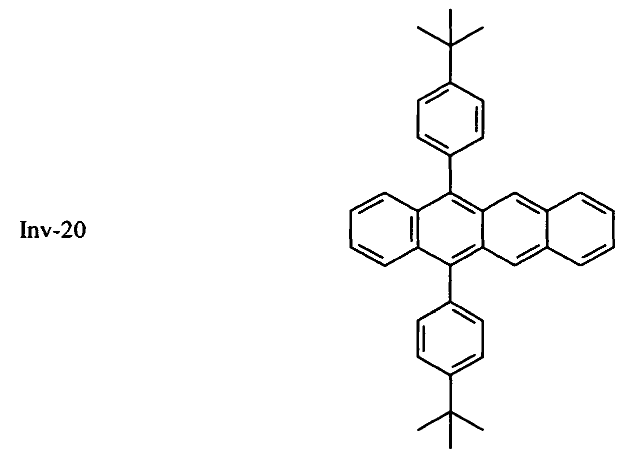

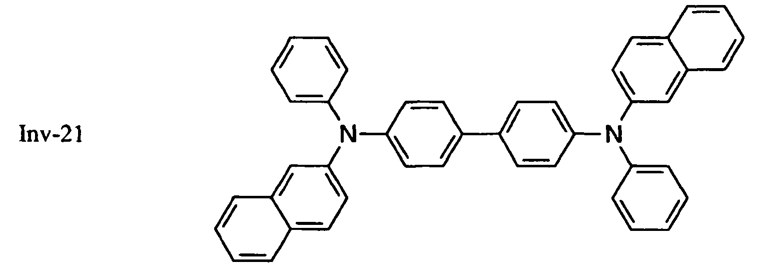

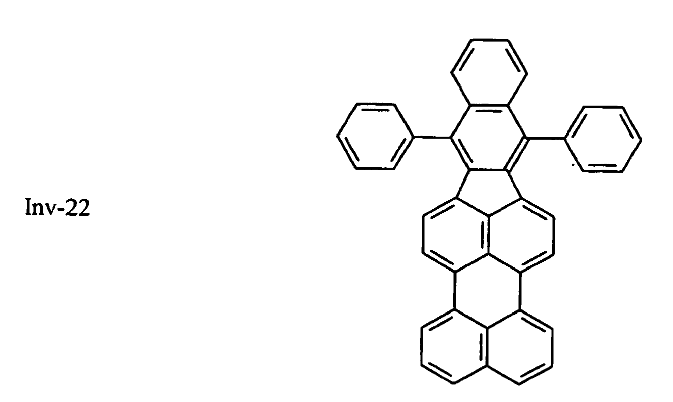

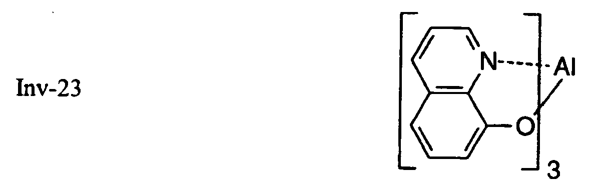

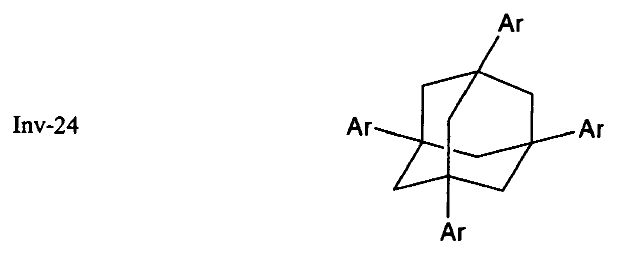

## Patentansprüche

1. OLED-Vorrichtung mit einer lichtemittierenden Schicht aus einer elektrolumineszierenden Komponente, die eine erste Bandlücke aufweist, und mindestens zwei nicht elektrolumineszierenden Komponenten, die eine zweite Bandlücke bzw. weitere Bandlücken aufweisen, worin:
i) die zweite Bandlücke gleich groß oder größer als die erste Bandlücke ist, jedoch nicht mehr als 2,7 eV;
ii) die weiteren Bandlücken größer als die erste und zweite Bandlücke sind;
iii) die nicht elektrolumineszierende Komponente mit der zweiten Bandlücke in einer Menge von mindestens 34 Gew.-% der gesamten Komponenten in der lichtemittierenden Schicht vorhanden ist;
iv) die nicht elektrolumineszierenden Komponenten mit weiteren Bandlücken in einer kombinierten Menge von 0,1 bis 65,9 Gew.-% der gesamten Komponenten in der lichtemittierenden Schicht vorhanden sind; und
v) die elektrolumineszierende Komponente in einer Menge von 0,1 bis 5 Gew.-% der gesamten Komponenten in der lichtemittierenden Schicht vorhanden ist.

2. OLED-Vorrichtung nach Anspruch 1, worin die elektrolumineszierende Komponente mit der ersten Bandlücke ein Periflanthenderivat ist, dargestellt durch folgende Formel (1): 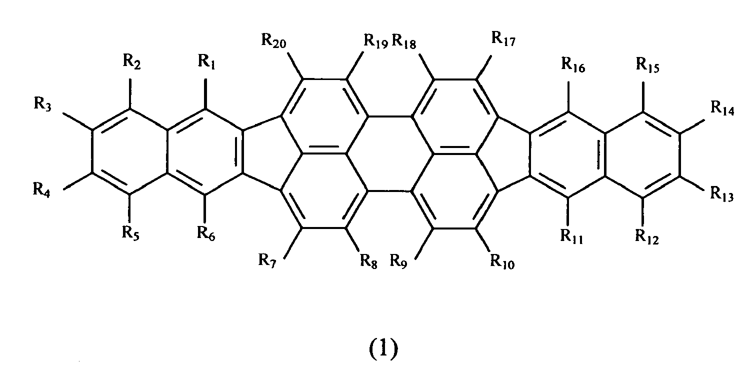 worin:
R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀ unabhängig als Wasserstoff oder Substituenten ausgewählt sind;
vorausgesetzt, dass sich jeder beliebige der bezeichneten Substituenten zur Bildung weiterer kondensierter Ringe zu verbinden vermag.

3. OLED-Vorrichtung nach Anspruch 2, worin mindestens ein R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀ aus der Gruppe unabhängig ausgewählt ist, die aus Halogenid-, Alkyl-, Aryl-, Alkoxy- und Aryloxygruppen besteht.

4. OLED-Vorrichtung nach Anspruch 3, worin mindestens ein Substituent eine Phenylgruppe ist.

5. OLED-Vorrichtung nach Anspruch 2, worin die nicht elektrolumineszierende Komponente mit der zweiten Bandlücke wünschenswerterweise im Bereich von 40 bis 75 Gew.-% der gesamten Komponenten in der lichtemittierenden Schicht liegt.

6. OLED-Vorrichtung nach Anspruch 2, worin die Periflanthenverbindung durch eine der folgenden Formeln dargestellt ist:

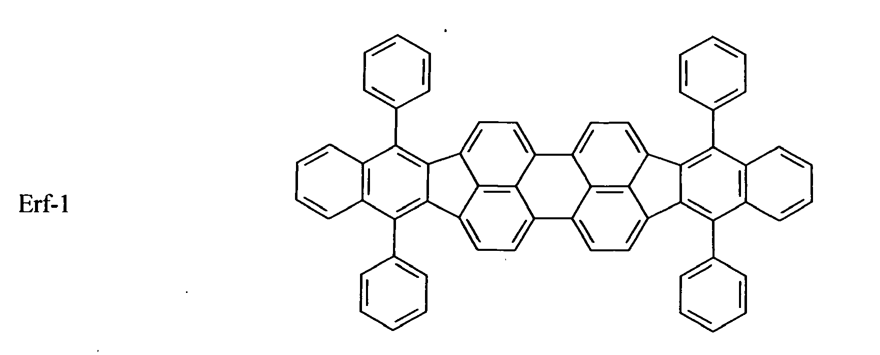

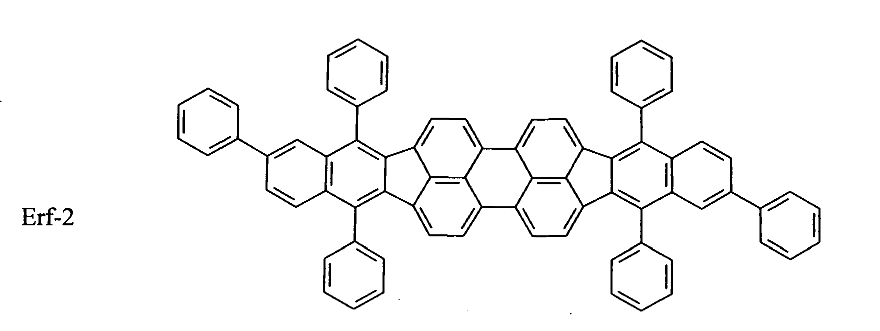

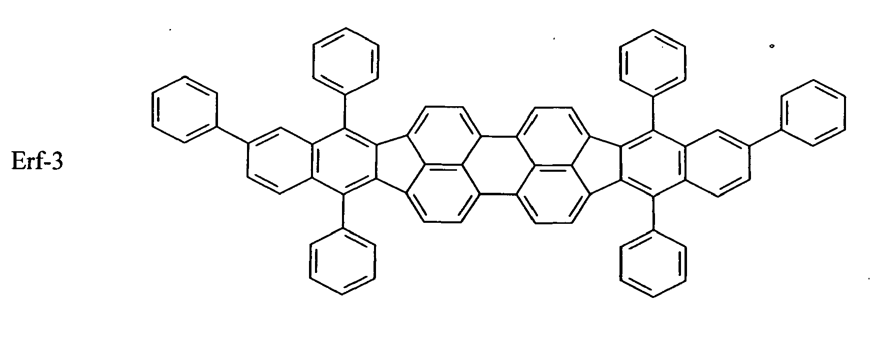

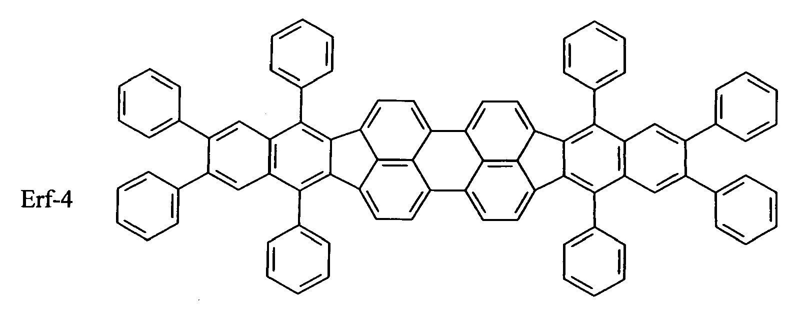

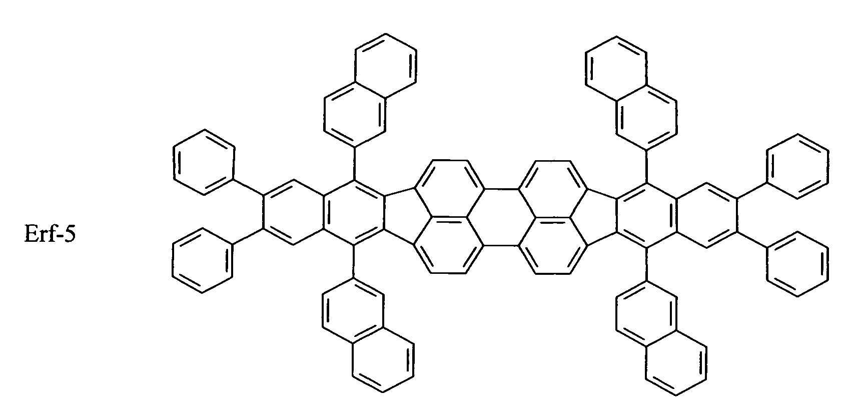

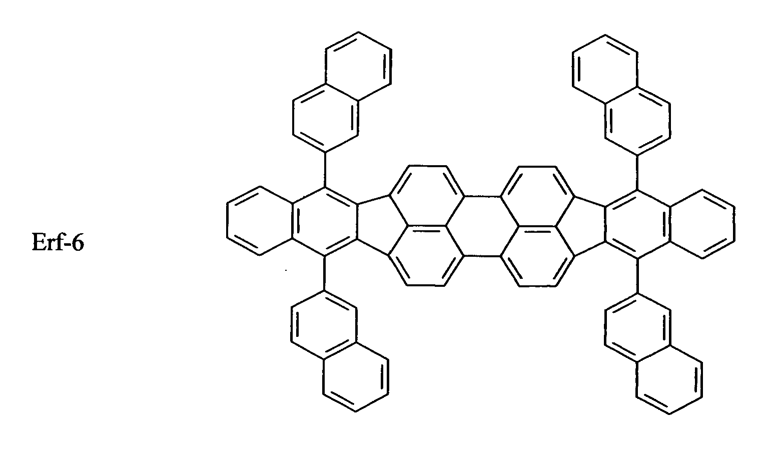

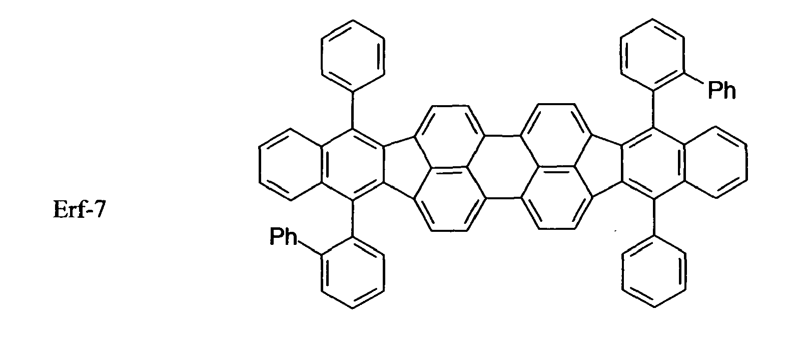

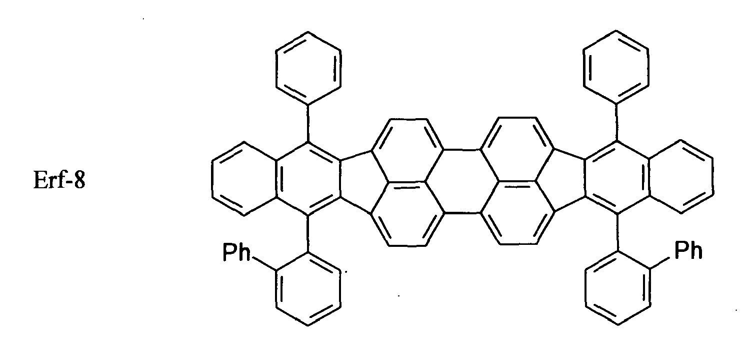

7. OLED-Vorrichtung nach Anspruch 1, worin die elektrolumineszierende Komponente mit der ersten Bandlücke ein Pyranderivat ist, dargestellt durch folgende Formel (2): 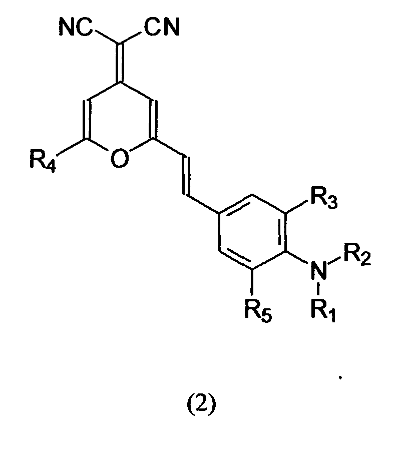 worin:
R₁, R₂, R₃, R₄ und R₅ unabhängig als Wasserstoff oder Substituenten ausgewählt sind;
vorausgesetzt, dass sich jeder beliebige der bezeichneten Substituenten zur Bildung weiterer kondensierter Ringe zu verbinden vermag.

8. Vorrichtung nach Anspruch 7, worin die Verbindung aus Formel (2) durch eine der folgenden Formeln dargestellt ist:

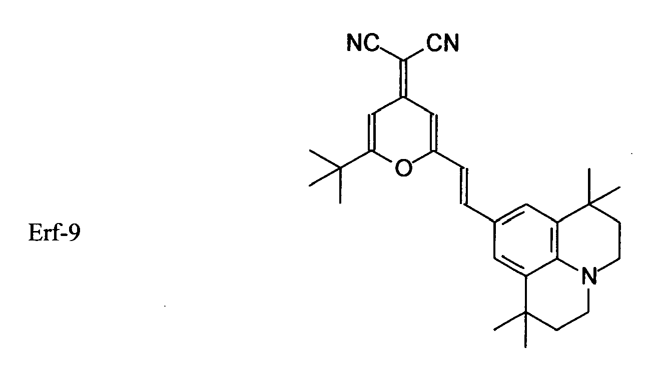

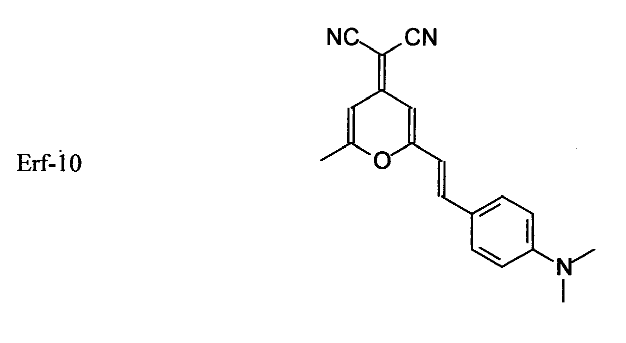

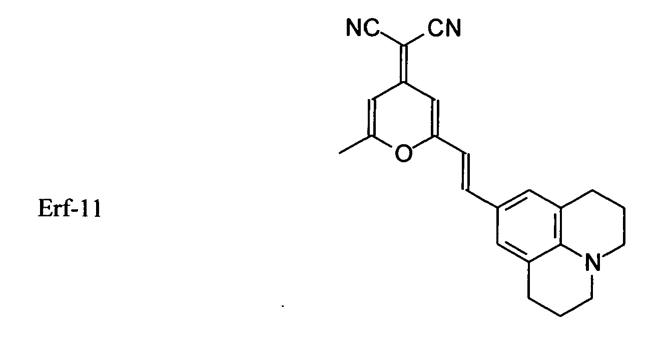

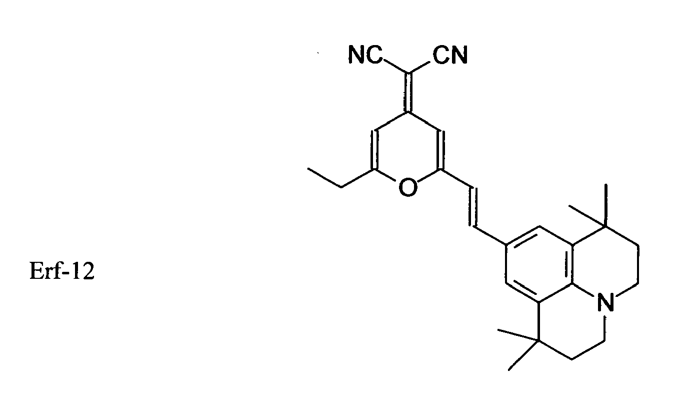

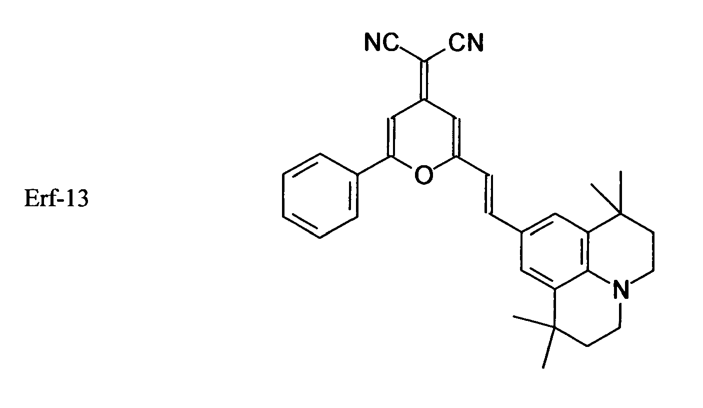

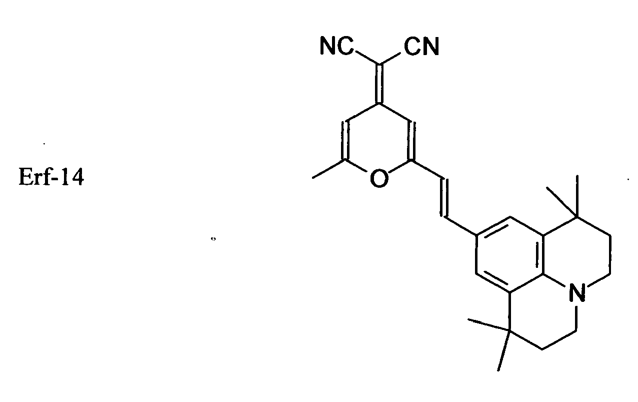

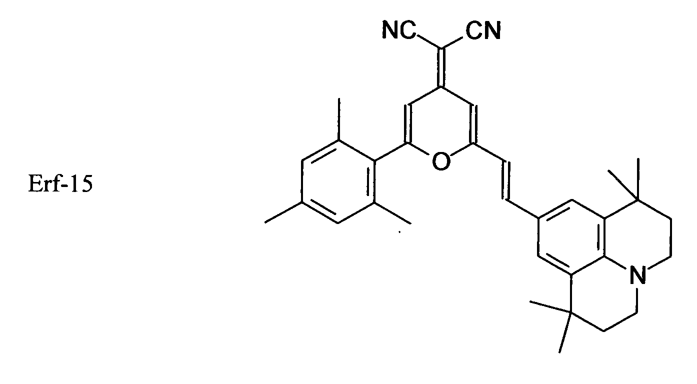

9. Vorrichtung nach Anspruch 1, worin die nicht elektrolumineszierende Komponente mit der zweiten Bandlücke ein Naphthacen ist, dargestellt durch folgende Formel (3): 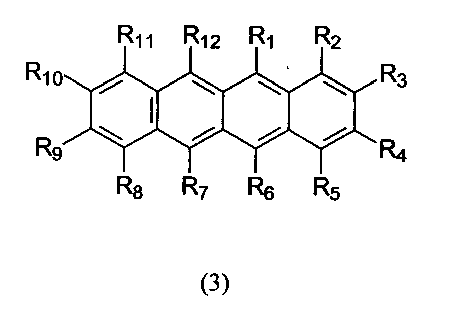 worin:
R₁, R₂, R₃, R₄, R₅, R₆, R₇, R₈, R₉, R₁₀, R₁₁ und R₁₂ unabhängig als Wasserstoff oder Substituenten ausgewählt sind;
vorausgesetzt, dass sich jeder beliebige der bezeichneten Substituenten zur Bildung weiterer kondensierter Ringe zu verbinden vermag.

10. Vorrichtung nach Anspruch 1, worin die nicht elektrolumineszierende Komponente mit einer weiteren Bandlücke aus folgenden Verbindungen ausgewählt ist:

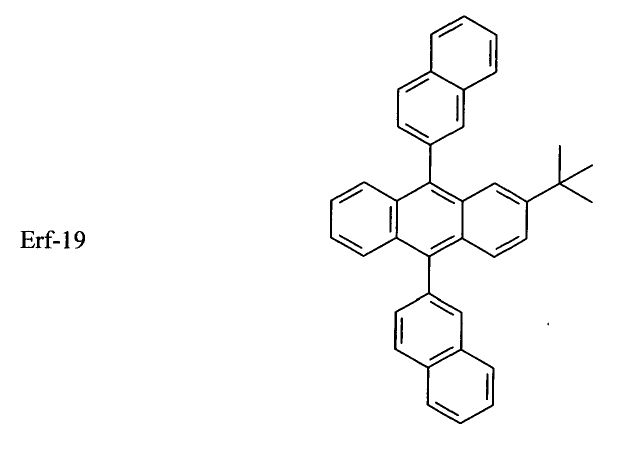

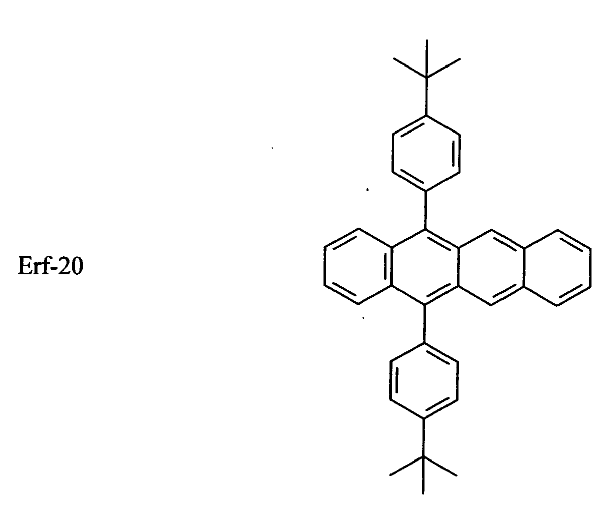

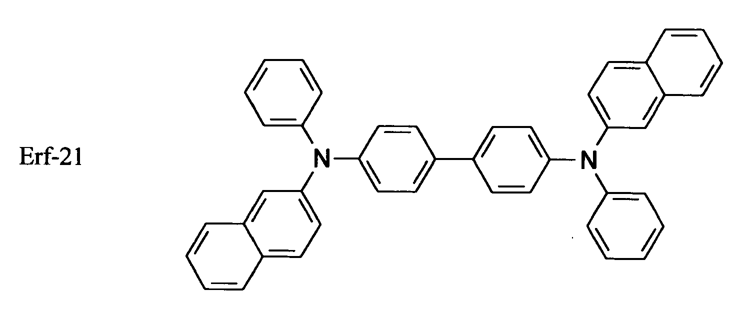

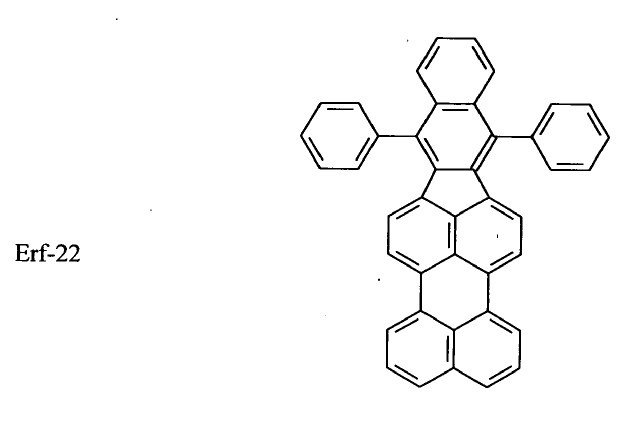

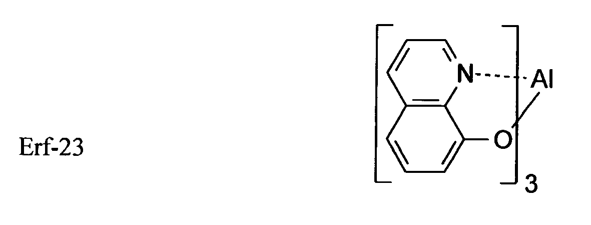

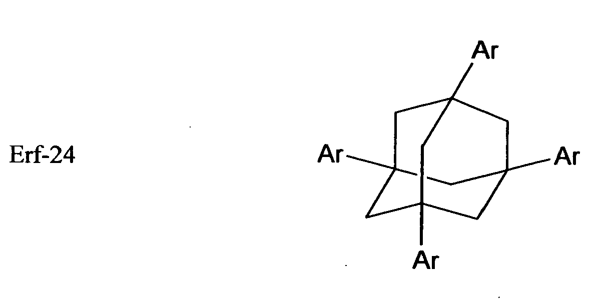

## Revendications

1. Dispositif OLED comprenant une couche électroluminescente contenant un composant électroluminescent ayant une première bande interdite et au moins deux composants non électroluminescents ayant respectivement une seconde bande interdite et d'autres bandes interdites, dans lequel :
i) la seconde bande interdite est égale ou supérieure à la première bande interdite mais ne dépasse pas 2,7 eV ;
ii) les autres bandes interdites sont supérieures à la première bande interdite et à la seconde bande interdite ;
iii) le composant non électroluminescent ayant la seconde bande interdite représente une quantité d'au moins 34% en poids de la totalité des composants de la couche électroluminescente ;
iv) les composants non électroluminescents ayant d'autres bandes interdites représentent une quantité combinée de 0,1 à 65,9% en poids de la totalité des composants de la couche électroluminescente ; et
v) le composant électroluminescent représente une quantité de 0,1 à 5% en poids de la totalité des composants de la couche électroluminescente.

2. Dispositif OLED selon la revendication 1, dans lequel le composant électroluminescent ayant la première bande interdite est un dérivé périflanthène représenté par la formule (1): 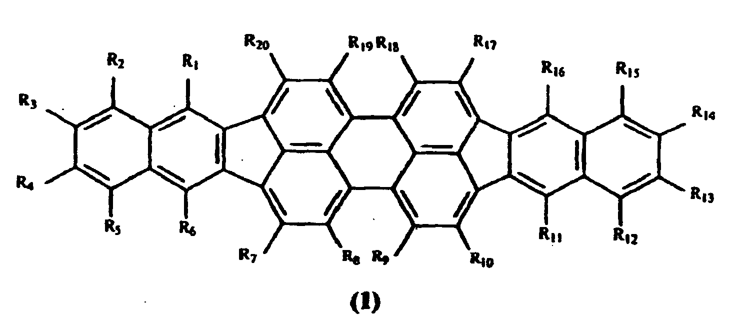 où :
R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀ sont indépendamment sélectionnés comme étant l'hydrogène ou des substituants ;
à la condition que l'un quelconque des substituants indiqués puisse être joint pour former d'autres cycles condensés.

3. OLED selon la revendication 2, dans lequel au moins l'un des groupes R₁, R₂, R₃, R₄, R₅, R₆, R₇, R₈, R₉, R₁₀, R₁₁, R₁₂, R₁₃, R₁₄, R₁₅, R₁₆, R₁₇, R₁₈, R₁₉, R₂₀ sont indépendamment sélectionnés parmi le groupe comprenant les groupes halogénure, alkyle, aryle, alcoxy et aryloxy.

4. OLED selon la revendication 3, dans lequel au moins un substituant est un groupe phényle.

5. OLED selon la revendication 2, dans lequel il est souhaitable que le composant non électroluminescent ayant la seconde bande interdite représente de 40 à 75% en poids de la totalité des composants de la couche électroluminescente.

6. OLED selon la revendication 2, dans lequel le composé périflanthène est représenté par l'une des formules suivantes :

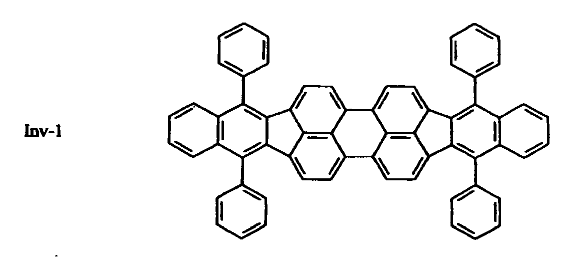

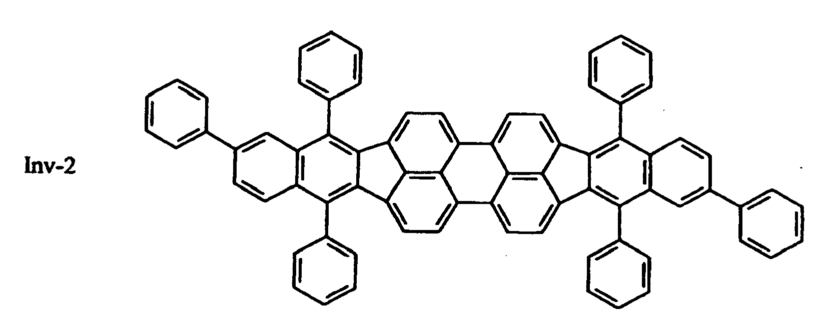

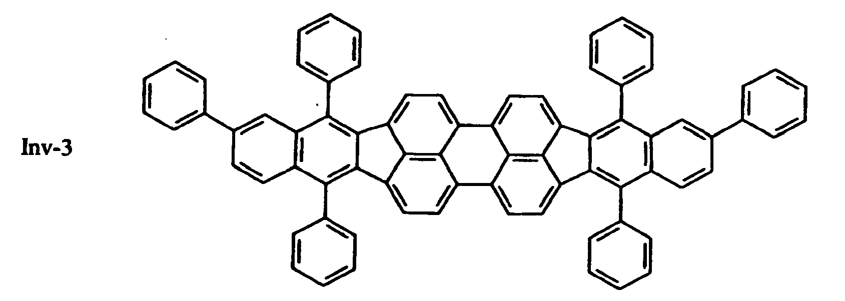

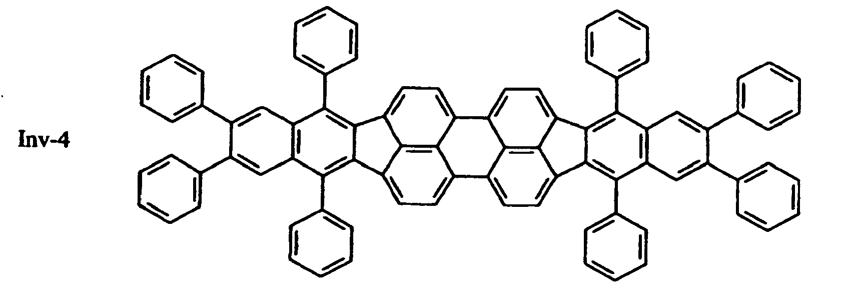

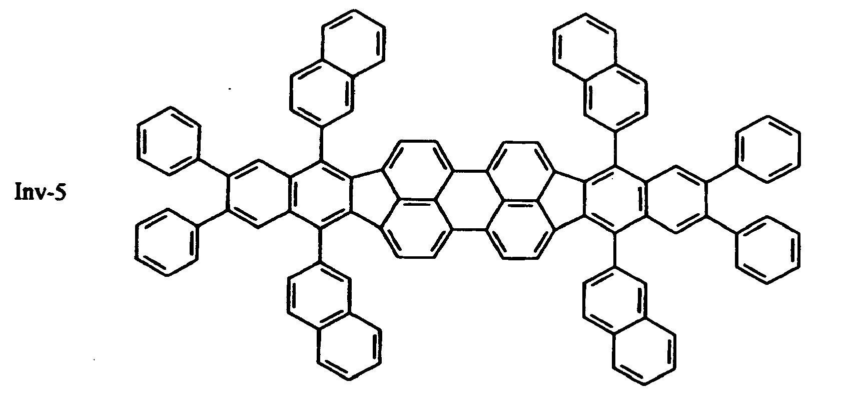

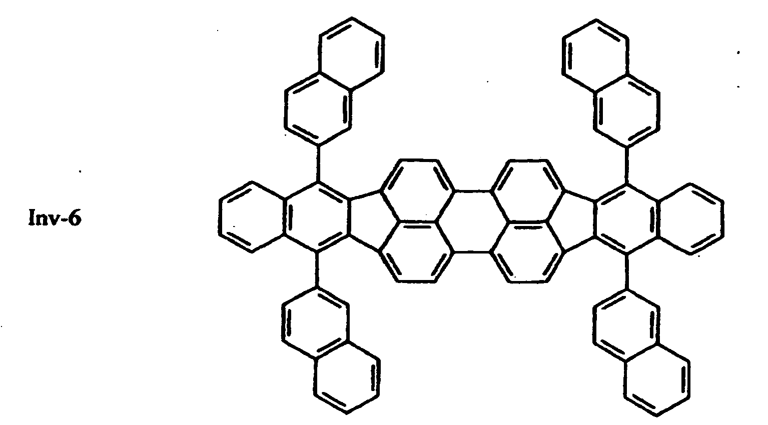

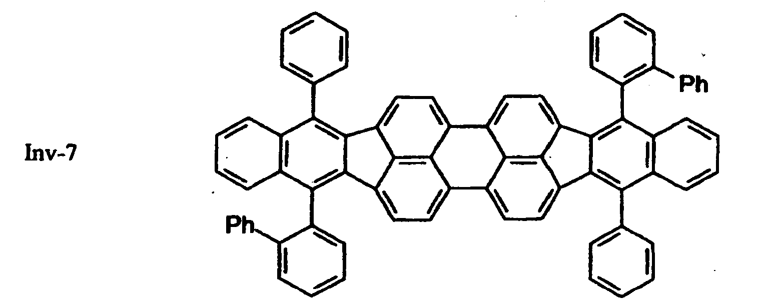

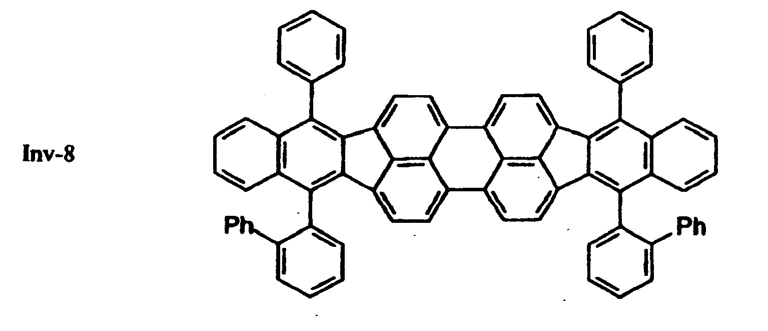

7. Dispositif OLED selon la revendication 1, dans lequel le composant électroluminescent ayant la première bande interdite est un dérivé pyrane représenté par la formule (2) : 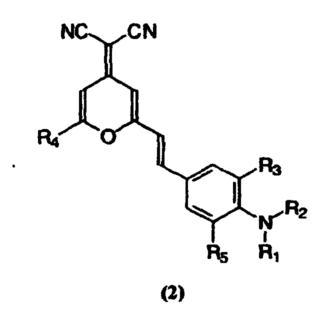 où :
R₁, R₂, R₃, R₄, et R₅ sont indépendamment sélectionnés comme étant l'hydrogène ou des substituants ;
à la condition que l'un quelconque des substituants indiqués puisse être joint pour former d'autres cycles condensés.

8. Dispositif selon la revendication 7, dans lequel le composé de formule (2) est représenté par l'une des formules suivantes :
| | |
|---|---|
| Inv-9 | 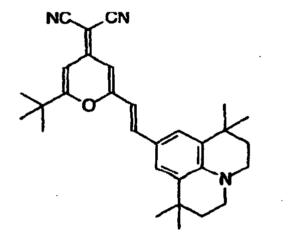 |
| Inv-10 | 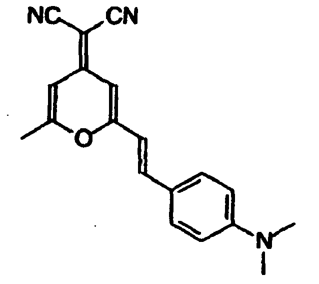 |
| Inv-11 | 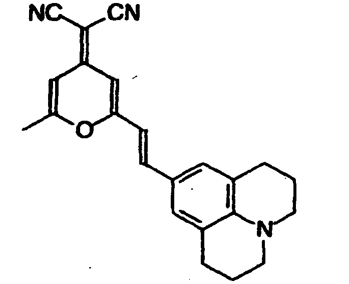 |
| Inv-12 | 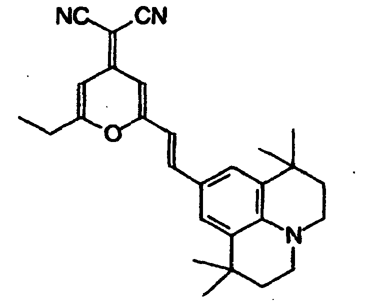 |
| Inv-13 | 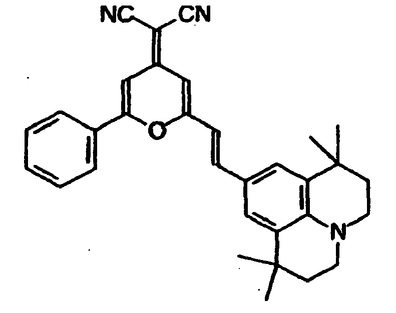 |
| Inv-14 | 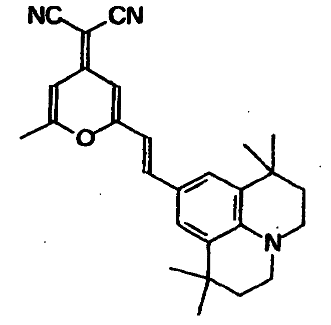 |
| Inv-15 | 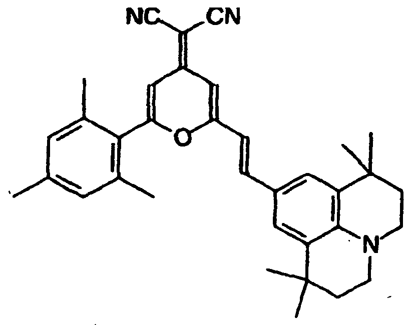 |

9. Dispositif selon la revendication 1, dans lequel le composant non électroluminescent ayant la seconde bande interdite est un composé naphtacène représenté par la formule (3) : 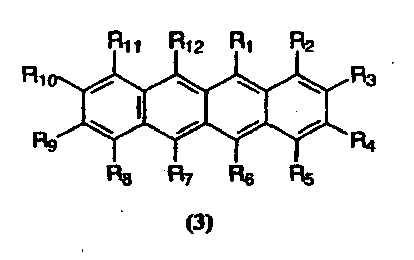 où:
R₁, R₂, R₃, R₄, R₅, R₆, R₇, R₈, R₉, R₁₀, R₁₁, et R₁₂ sont indépendamment sélectionnés comme étant l'hydrogène ou des substituants ;
à la condition que l'un quelconque des substituants indiqués puisse être joint pour former d'autres cycles condensés.

10. Dispositif selon la revendication 1, dans lequel le composant non électroluminescent ayant une autre bande interdite est sélectionné parmi les composés suivants :
